(19) Europäisches Patentamt
European Patent Office
Office européen des brevets

(11) EP 1 622 919 B2

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**15.08.2012 Patentblatt 2012/33**

(45) Hinweis auf die Patenterteilung:
**12.08.2009 Patentblatt 2009/33**

(21) Anmeldenummer: **04739121.4**

(22) Anmeldetag: **30.04.2004**

(51) Int Cl.:
***C07F 15/00*** *(2006.01)* ***H01L 51/00*** *(2006.01)*
***H05B 33/00*** *(2006.01)* ***C09K 11/00*** *(2006.01)*

(86) Internationale Anmeldenummer:
**PCT/EP2004/004610**

(87) Internationale Veröffentlichungsnummer:
**WO 2004/099223 (18.11.2004 Gazette 2004/47)**

# (54) VERFAHREN ZUR HERSTELLUNG VON TRIS-ORTHO-METALLIERTEN ORGANOMETALLKOMPLEXEN UND VERWENDUNG SOLCHER KOMPLEXE IN OLEDS

METHOD FOR PRODUCING TRIS-ORTHO-METALLATED COMPLEXES AND USE OF SUCH COMPLEXES IN OLEDS

PROCEDE DE PRODUCTION DE COMPLEXES ORGANOMETALLIQUES TRIS-ORTHO-METALLES ET UTILISATION DE CES COMPLEXES DANS DES OLED

(84) Benannte Vertragsstaaten:
**AT BE BG CH CY CZ DE DK EE ES FI FR GB GR HU IE IT LI LU MC NL PL PT RO SE SI SK TR**

(30) Priorität: **05.05.2003 DE 10320103**

(43) Veröffentlichungstag der Anmeldung:
**08.02.2006 Patentblatt 2006/06**

(73) Patentinhaber: **BASF SE**
**67056 Ludwigshafen (DE)**

(72) Erfinder:
- **BOLD, Markus**
  **67246 Dirmstein (DE)**
- **ERK, Peter**
  **67227 Frankenthal (DE)**
- **HADDOW, Mairi**
  **Blairgowrie, Central Scotland PH106EN (GB)**
- **HENNIG, Ingolf**
  **68809 Neulussheim (DE)**
- **SCHMIDT, Hans-Werner**
  **95444 Bayreuth (DE)**
- **BÄTE, Markus**
  **95508 Kulmain (DE)**
- **THELAKKAT, Mukundan**
  **95445 Bayreuth (DE)**

(74) Vertreter: **Isenbruck, Günter**
**Isenbruck Bösl Hörschler LLP**
**Eastsite One**
**Seckenheimer Landstrasse 4**
**68163 Mannheim (DE)**

(56) Entgegenhaltungen:
**DE-A- 10 104 426 US-A1- 2003 068 526**

- **COLOMBO M G ET AL: "FACIAL TRIS CYCLOMETALATED RH3+ AND IR3+ COMPLEXES: THEIR SYNTHESIS, STRUCTURE, AND OPTICAL SPECTROSCOPIC PROPERTIES" INORGANIC CHEMISTRY, AMERICAN CHEMICAL SOCIETY, EASTON, US, Bd. 33, Nr. 33, 1994, Seiten 545-550, XP001070333 ISSN: 0020-1669**

EP 1 622 919 B2

## Beschreibung

Die vorliegende Erfindung betrifft ein Verfahren zur Herstellung von tris-ortho-metallierten Iridiumkomplexen.

Der Iridium-tris(phenylpyridin)-Komplex ($Irppy_3$) ist einer der wichtigsten Bausteine auf dem Gebiet der Triplettemitter. Im Stand der Technik ist der Einsatz von $Irppy_3$ auf diesem Gebiet in zahlreichen Veröffentlichungen beschrieben. Ein Vorteil dieser Verbindungsklasse ist es, dass im Gegensatz zu den üblicherweise verwendeten Fluoreszenzfarbstoffen die zu 75% populierten Triplettzustände ebenfalls in einer Emission genutzt werden können, so dass sich unter Voraussetzung eines schnellen sogenannten Intersystem Crossing (ISC) eine theoretische Quantenausbeute von 100 % ergeben kann.

R.J. Watts et al., J. Am. Chem. Soc. 1984, 106, 6647 - 6653 beschreiben den ersten Zugang zu $Irppy_3$ durch eine direkte Zyklometallierung von $IrCl_3$ x 3 $H_2O$ mit Phenylpyridin. Allerdings wird das gewünschte $Irppy_3$ nur in einer Ausbeute von 10 % erhalten, während der überwiegende Anteil des gewonnenen Ir-Komplexes als dinuklearer sogenannter μ-Chloro-Komplex ausfällt.

R.J. Watts et al., Inorg. Chem. 1991, 30, 1685 - 1687 betrifft die Herstellung von $Irppy_3$ ausgehend von dem vorstehend erwähnten μ-Chloro-Komplex durch Aufbrechen des Aggregats mittels 2,4-Pentadion und anschließende weitere (dritte) Zyklometallierung mit Phenylpyridin. Des Weiteren ist die direkte Herstellung von $Irppy_3$ ausgehend von $Ir(acac)_3$ (acac = Acetylacetonat) in Glycerin bei 200 °C offenbart. Nachteilig dabei ist, dass bei dieser Umsetzung ein komplexes Nebenproduktspektrum auftritt, welches durch übliche Reinigungsoperationen (Kristallisation, Chromatographie, Sublimation) nicht oder nur mit sehr großem Aufwand zu entfernen ist.

Bürgi et al., Inorg. Chem. 1994, 33, 545 - 550 betrifft die Herstellung von $Irppy_3$ ausgehend von dem μ-Chloro-Komplex durch Umsetzung mit AgOTf (Tf = Trifluoroacetat), wodurch eine Weiterreaktion mit Phenylpyridin induziert werden kann.

Die allgemeine Formel des vorstehend erwähnten μ-Chloro-Komplexes ist nachstehend aufgeführt:

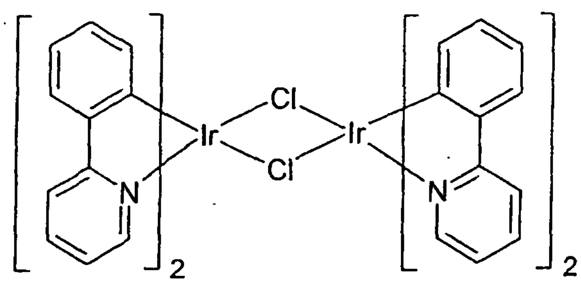

Neben dem Licht im grünen Bereich des elektromagnetischen Spektrums emittierenden Ir-Komplex $Irppy_3$ sind leistungsfähige Emittermoleküle von Interesse, die Licht im roten Bereich des elektromagnetischen Spektrums emittieren.

In A. Tsuboyama et al. J. Am. Chem. Soc. 2003, 125, 12971 - 12979 sind Ir(III)-Komplexe des Phenylisochinolins offenbart, die im roten Bereich des elektromagnetischen Spektrums Licht emittieren. Die Herstellung erfolgt ausgehend von $Ir(acac)_3$ durch Umsetzung mit Phenylisochinolin. Der gewünschte Komplex wird in einer Ausbeute von 27 % erhalten.

Su et al. Adv. Mater. 2003, 15, 884 - 888 betrifft die Herstellung substituierter Ir-Phenylisochinolinkomplexe. Diese werden durch mehrstufige Reaktionsführung hergestellt, wobei ein Chloro-verbrücktes Ir-Dimer mit einem Überschuss Ligand in Gegenwart von $Ag(CF_3SO_3)$ zu dem gewünschten Ir-Komplex umgesetzt wird.

EP-A 1 191 612 betrifft Licht-emittierende Dioden, die tris-ortho-metallierte Komplexe des Ir, Rh oder Pd enthalten. Unter anderem sind Ir-Komplexe des 2-Benzo[b]thiophen-2-yl-pyridins offenbart. Die Synthese erfolgt ausgehend von $Ir(acac)_3$ durch Umsetzung mit 2-Benzo[b]thiophen-2-yl-pyridin. Der gewünschte Komplex wird mit einer Ausbeute von 23 % erhalten.

WO 03/103341 betrifft OLEDs, die in der Licht-emittierenden Schicht ein phosphoreszierendes Licht-emittierendes Material enthalten. Als rotes Licht emittierendes Material wird der tris-ortho-metallierte Ir-Komplex von Phenylisochinolin eingesetzt. Ein Verfahren zur Herstellung des Ir-Komplexes ist nicht angegeben.

WO 03/040256 betrifft rot-oranges oder rotes Licht emittierende Ir(III)-Komplexe. Unter anderem wird der tris-ortho-metallierte Ir-Komplex von deutiertem Phenylisochinolin offenbart. Die Herstellung des Komplexes erfolgt über die Herstellung des μ-Chloro-Komplexes. Des Weiteren wird der zwei Phenylisochinolin-Liganden und einen acac-Liganden aufweisende Ir(III)-Komplex offenbart.

EP-A 1 239 526 betrifft Metallkomplexe der Formel $ML_mL'_n$, wobei M unter anderem Ir sein kann und L und L' verschiedene bidentate Liganden sind, wobei n gegebenenfalls 0 sein kann. Die Komplexe werden entweder über die Herstellung der μ-Cbloro-Komplexe oder ausgehend von den entsprechenden acac-Komplexen hergestellt.

Vladimir V. Grushin et al., Chem. Commun., 2001, 1494-1495 betrifft Ir(III)-Komplexe, die fluorierte Phenylpyridine als Liganden enthalten und deren Einsatz in OLEDs. Die Herstellung der Ir(III)-Komplexe erfolgt durch Umsetzung von $IrCl_3$ mit fluorierten 2-Arylpyridinen in Anwesenheit von $AgO_2CCF_3$. Die Devicedaten der OLEDs enthaltend die genannten Ir(III)-Komplexe sind jedoch verbesserungswürdig.

WO 02/02714 betrifft elektrolumineszierende Ir(III)-Komplexe, die fluorierte Phenylpyridine, Phenylpyrimidine oder Phenylchinoline als Liganden aufweisen, sowie elektronische Vorrichtungen, deren aktive Schicht einen elektrolumineszierenden Ir(III)-Komplexe enthält. Die Herstellung von Iridium(III)-Komplexen mit fluorierten Phenylpyridinen kann dabei durch Umsetzung der fluorierten Phenylpyridine mit $IrCl_3$-Hydrat in Anwesenheit von Ag(OTf) in Abwesenheit von Lösungsmittel erfolgen.

DE-A 101 04 426 betrifft ein Verfahren zur Herstellung von hochreinen, tris-ortho-metallierten Organo-Iridium-Verbindungen wie Ir(ppy)3. Die genannten Verbindungen können durch Umsetzung $Ir(acac)_3$ (acac = Acetylacetonat) mit entsprechenden organischen Liganden, im Fall von $Ir(ppy)_3$ Phenylpyridin, in einem bipolar protischen Lösungsmittel oder durch Umsetzung des entsprechenden organischen Liganden, im Fall von $Ir(ppy)_3$ Phenylpyridin, zu dem entsprechenden Lithiumsalz und anschließender Umsetzung mit einer Ir(III)- Verbindung, z.B. Iridium(III)-chlorid, bei tiefen Temperaturen hergestellt werden. Die hochreinen Verbindungen werden erst nach aufwändiger HPLC erhalten.

Aufgabe der vorliegenden Anmeldung ist die Bereitstellung eines Verfahrens zur Herstellung von tris-orthometallierten Ir-Komplexen, das einfach (einstufig) ist und worin die hochreinen Ir-Komplexe ohne aufwändige Reinigungsschritte herstellbar sind.

Diese Aufgabe wird gelöst durch ein Verfahren zur Herstellung von Verbindungen der Formel (I)

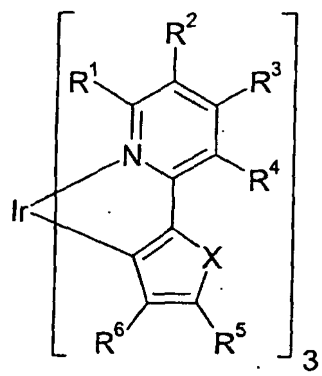

(I)

worin bedeuten

| | |
|---|---|
| X | $-CR^7=CR^8-$ -S-, $-NR^9-$, -O-, -Se-; |
| $R^1$, $R^2$, $R^3$, $R^4$, $R^5$, $R^6$,$R^7$ und $R^8$ | unabhängig voneinander H, geradkettiges oder verzweigtes $C_{1-20}$-Alkyl, cyclisches $C_{3-20}$-Alkyl, wobei eine oder mehrere nicht benachbarte $CH_2$- Gruppen der Alkylgruppen durch -O-, -S-, $-NR^{10}-$, oder $-CONR^{11}-$ ersetzt sein können und ein oder mehrere H-Atome der Alkylgruppen durch F, Cl, Br oder CN ersetzt sein können; Aryl oder Heteroaryl mit einem Grundgerüst mit 4 bis 14 C-Atomen, wobei ein oder mehrere C-Atome durch Heteroatome ausgewählt aus -O-, -S-, -N- und -P- ersetzt sein können, und die C-Atome und gegebenenfalls die Heteroatome mit nicht aromatischen Substituenten; wie für $R^1$ bis $R^8$ definiert, substituiert sein können; F, Cl, Br oder CN;<br>oder<br>zwei benachbarte Reste $R^1$, $R^2$, $R^3$, $R^4$, $R^5$, $R^6$, $R^7$ und $R^8$ bilden gemeinsam einen cyclischen Rest, der wiederum mit den bezüglich $R^1$, $R^2$, $R^3$, $R^4$, $R^5$, $R^6$, $R^7$ und $R^8$ genannten Gruppen substituiert sein kann, wobei zwei benachbarte Substituenten des cyclischen Rests wiederum einen cyclischen Rest bilden können; |
| $R^9$, $R^{10}$, $R^{11}$ | unabhängig voneinander H, geradkettiges oder verzweigtes $C_{1-20}$-Alkyl, cyclisches $C_{3-20}$-Alkyl, das wie bezüglich der Reste $R^1$ bis $R^8$ definiert substituiert sein kann, oder Aryl oder Heteroaryl wie bezüglich $R^1$ bis $R^8$ definiert; |

durch Umsetzung eines Liganden der Formel (II)

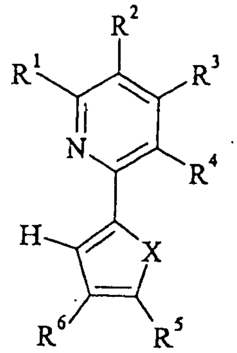

(II)

worin die Symbole $R^1$, $R^2$, $R^3$, $R^4$, $R^5$, $R^6$ und X die vorstehend genannten Bedeutungen aufweisen,
mit einem Iridiumhalogenid oder -pseudohalogenid der Formel $IrZ_3$ oder $IrZ_3 \cdot L_x$, worin Z ein Halogenid oder Pseudohalgenid bedeutet und L ein organisches oder anorganisches Molekül ist, und x die Anzahl von L ist und 1 bis 3, bevorzugt 3, ist; z.B. kann $IrZ_3 . L_x$

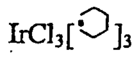

bedeuten;
in Anwesenheit eines Halogenid-Fängers ausgewählt aus der Gruppe bestehend aus Ag-, Hg-, Sb- und Al-Salzen, in einem Lösungsmittel ausgewählt aus der Gruppe bestehend aus Monoaryloxyethanol, Monoalkyloxyethanol, Decalin, Glycerin und Gemischen der vorstehend genannten Lösungsmittel,
wobei die Reaktionsdauer 0,1 bis 24 Stunden beträgt,
und das Verhältnis von Iridiumhalogenid- oder pseudohalogenid, ligand der Formel II und Halogenidfänger 1:6 bis 10 : 3,1 bis 3,5 beträgt.

Bevorzugt bedeutet, X $-CR^7=CR^8-$ oder -S-, wobei $R^7$ und $R^8$ bevorzugt unabhängig voneinander H, F oder $C_{1-10}$-Alkyl, das geradkettig oder verzweigt sein kann, besonders bevorzugt H oder F, bedeuten. Besonders bevorzugt ist mindestens $R^7$ oder $R^8$ H und der weitere Rest ist H, F oder $C_{1-10}$-Alkyl, das geradkettig oder verzweigt sein kann, bevorzugt H oder F. Ganz besonders bevorzugt sind $R^7$ und $R^8$ H. Somit ist X ganz besonders bevorzugt -CH=CH- oder -S-.

$R^1$, $R^2$, $R^3$, $R^4$, $R^5$ und $R^6$ bedeuten bevorzugt unabhängig voneinander H; geradkettiges oder verzweigtes $C_{1-10}$-Alkyl, wobei eine oder mehrere nicht benachbarte $CH_2$-Gruppen der Alkylgruppen durch -O- oder $-NR^{10}-$ ersetzt sein können, d. h. $R^1$ bis $R^6$ können Alkoxy- oder Aminoreste bedeuten, und ein oder mehrere H-Atome der Alkylgruppen können durch F, Cl, Br oder CN ersetzt sein; Aryl öder Heteroaryl mit einem Grundgerüst mit 5 oder 6 C-Atomen, wobei ein oder mehrere C-Atome durch Heteroatome ausgewählt aus -O-, -S- und -N- ersetzt sein können;
oder
zwei benachbarte Reste $R^1$ bis $R^6$ bilden gemeinsam einen cyclischen Rest, der wiederum mit den bezüglich mit den für $R^1$ bis $R^6$ genannten Gruppen substituiert sein kann, bevorzugt einen 5- oder 6-gliedrigen cyclischen Rest, der gesättigt oder ungesättigt und substituiert oder unsubstituiert sein kann, besonders bevorzugt einen 6-gliedrigen aromatischen Rest, der unsubstituiert ist; ganz besonders bevorzugt bilden $R^3$ und $R^4$ oder $R^5$ und $R^6$ gemeinsam einen 6-gliedrigen aromatischen Rest, der unsubstituiert ist, und die weiteren Reste bilden keine cyclischen Reste.

$R^9$, $R^{10}$, $R^{11}$ bedeuten bevorzugt unabhängig voneinander H, geradkettiges oder verzweigtes $C_{1-10}$-Alkyl, oder Aryl oder Heteroaryl wie bezüglich $R^1$ bis $R^6$ definiert. Ganz besonders bevorzugt bedeuten $R^9$, $R^{10}$, $R^{11}$ unabhängig voneinander H, $C_{1-3}$-Alkyl oder $C_6$-Aryl, das gegebenenfalls substituiert sein kann. Ganz besonders bevorzugt bedeuten $R^9$, $R^{10}$, $R^{11}$ unabhängig voneinander H, Methyl, Ethyl oder Phenyl.

In einer besonders bevorzugten Ausführungsform bedeuten

X $-CR^7=CR^8-$, wobei $R^7$ und $R^8$ bevorzugt unabhängig voneinander H, F oder $C_{1-10}$- Alkyl bedeuten, das geradkettig oder verzweigt sein kann, besonders bevorzugt H oder F, wobei ganz besonders bevorzugt mindestens $R^7$ oder $R^8$ H bedeutet, insbesondere bevorzugt -CH=CH-

und

$R^1$, $R^2$, $R^3$, $R^4$, $R^5$, $R^6$ unabhängig voneinander H, geradkettiges oder verzweigtes $C_{1-10}$-Alkyl, wobei eine oder mehrere nicht benachbarte $CH_2$-Gruppen der Alkylgruppen durch -O- oder -$NR^{10}$- ersetzt sein können, d. h. $R^1$ bis $R^6$ können Alkoxy- oder Aminoreste bedeuten, und ein oder mehrere H-Atome der Alkylgruppen können durch F, Cl, Br oder CN ersetzt sein; Aryl oder Heteroaryl mit einem Grundgerüst mit 5 oder 6 C-Atomen, wobei ein oder mehrere C-Atome durch Heteroatome ausgewählt aus - O-, -S- und -N- ersetzt sein können; bevorzugt sind $R^1$, $R^2$, $R^3$, $R^4$, $R^5$ und $R^6$ jeweils H.

In einer weiteren bevorzugten Ausführungsform bedeuten

X -$CR^7$=$CR^8$-, wobei $R^7$ und $R^8$ bevorzugt unabhängig voneinander H, F oder $C_{1-10}$- Alkyl, das geradkettig oder verzweigt sein kann, besonders bevorzugt H oder F, bedeuten, wobei ganz besonders bevorzugt mindestens $R^7$ oder $R^8$ H bedeutet, insbesondere bevorzugt -CH=CH-;

und

$R^1$ $R^2$, $R^5$ und $R^6$ unabhängig voneinander H, geradkettiges oder verzweigtes $C_{1-10}$-Alkyl, wobei eine oder mehrere nicht benachbarte $CH_2$-Gruppen der Alkylgruppen durch -O- oder -$NR^{10}$- ersetzt sein können, d. h. $R^1$, $R^2$, $R^5$ und $R^6$ können Alkoxy- oder Aminoreste bedeuten, und ein oder mehrere H-Atome der Alkylgruppen können durch F, Cl, Br oder CN ersetzt sein; Aryl oder Heteroaryl mit einem Grundgerüst mit 5 oder 6 C-Atomen, wobei ein oder mehrere C-Atome durch Heteroatome ausgewählt aus -O-, -S- und -N- ersetzt sein können; bevorzugt sind $R^1$, $R^2$, $R^5$ und $R^6$ jeweils H;

und

$R^3$ und $R^4$ bilden gemeinsam einen cyclischen Rest, der wiederum mit den bezüglich $R^1$, $R^2$, $R^5$ und $R^6$ genannten Gruppen substituiert sein kann, bevorzugt einen 5- oder 6- gliedrigen cyclischen Rest, der gesättigt oder ungesättigt und substituiert oder unsubstituiert sein kann, besonders bevorzugt einen 6-gliedrigen aromatischen Rest, der unsubstituiert ist.

In einer weiteren bevorzugten Ausführungsform bedeuten

X -S-,

und

$R^1$ , $R^2$ , $R^3$ und $R^4$ unabhängig voneinander H, geradkettiges oder verzweigtes $C_{1-10}$-Alkyl, wobei eine oder mehrere nicht benachbarte $CH_2$-Gruppen, der Alkylgruppen durch -O- oder -$NR^{10}$- ersetzt sein können, d. h. $R^1$, $R^2$, $R^3$ und $R^4$ können Alkoxy- oder Aminoreste bedeuten, und ein oder mehrere H-Atome der Alkylgruppen können durch F, Cl, Br oder CN ersetzt sein; Aryl oder Heteroaryl mit einem Grundgerüst mit 5 oder 6 C-Atomen, wobei ein oder mehrere C-Atome durch Heteroatome ausgewählt aus -O-, -S- und -N- ersetzt sein können; bevorzugt sind $R^1$, $R^2$, $R^3$ und $R^4$ jeweils H;

und

$R^5$, $R^6$ bilden gemeinsam einen cyclischen Rest, der wiederum mit den bezüglich $R^1$, $R^2$, $R^3$ und $R^4$ genannten Gruppen substituiert sein kann, bevorzugt einen 5- oder 6- gliedrigen cyclischen Rest, der gesättigt oder ungesättigt und substituiert oder unsubstituiert sein kann, besonders bevorzugt einen 6-gliedrigen aromatischen Rest, der unsubstituiert ist.

Ganz besonders bevorzugt betrifft die vorliegende Erfindung ein Verfahren zur Herstellung von Ir-Komplexen die die folgenden Formeln Ia, Ib und Ic aufweisen:

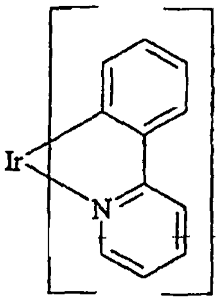 Ia

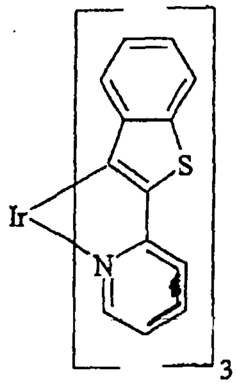 Ib

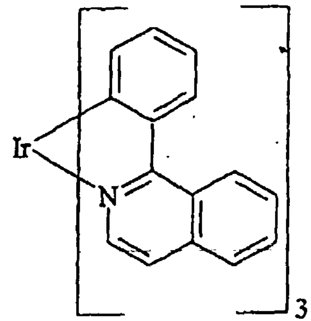 Ic

Irppy$_3$ Ir(btp)$_3$ Ir(piq)$_3$

durch Umsetzung der entsprechenden Liganden der Formeln IIa, IIb und IIc:

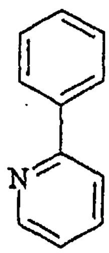 IIa

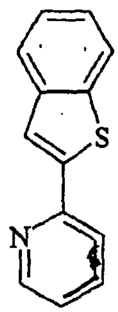 IIb

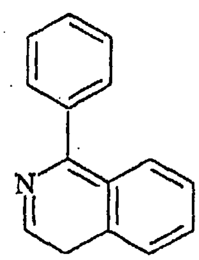 IIc.

ppy btp piq

Das erfindungsgemäße Verfahren zur Herstellung einer Verbindung der Formel I erfolgt durch Umsetzung einer Verbindung der Formel II mit einem Iridiumhalogenid oder -pseudohalogenid der Formel TrZ$_3$ oder IrZ$_3$·L$_x$, worin Z ein Halogenid, bevorzugt Br oder Cl, besonders bevorzugt Cl, oder ein Pseudohalogenid, bevorzugt ein Cyanid, Cyanat oder Thiocyanat, bedeutet, und L ein organisches oder anorganisches Molekül ist, das ein Donoratom enthält, z.B. Tetrahydrofuran, pyridin, Tetrahydrothiophen oder Wasser. x ist bevorzugt 1 bis 3.

Die Umsetzung erfolgt in Anwesenheit von einem Halogenidfänger ausgewählt aus der Gruppe bestehend aus Ag-, Hg-, Sb-, und Al-Salzen.

Dabei ist unter einem Halogenidfanger bzw. Pseudohalogenidfänger eine Verbindung (im Allgemeinen ein Salz) zu verstehen, die mit Halogenidionen bzw. Pseudohalogenidionen ein schwerlösliches Salz bildet.

Bevorzugte Halogenidfanger sind Ag(I)-Salze. Geeignete Ag(I)-Salze sind z.B. ausgewählt aus anorganischen Salzen wie $AgNO_3$, $Ag_2CO_3$, $Ag_2SO_4$, $AgClO_4$ und organischen Salzen wie Ag(OAc), Ag(OTf). Ganz besonders bevorzugt ist Ag(OTf).

Das erfindungsgemäße Verfahren wird in einem Lösungsmittel ausgewählt aus der Gruppe bestehend aus Monoaryloxyethanol wie Phenoxyethanol, Monoalkoxyethanol, Decalin, und Glycerin eingesetzt. Es ist auch möglich Gemische der vorstehend genannten Lösungsmittel einzusetzen. Ganz besonders bevorzugt werden Glycerin und Phenoxyethanol eingesetzt.

Das Verhältnis von Iridiumhalogenid oder -pseudohalogenid, Verbindung der Formel II und Halogenidfänger beträgt in dem erfindungsgemäßen Verfahren 1 : 6 bis 10 : 3,1 bis 3,5.

Das erfindungsgemäße Verfahren wird im Allgemeinen bei Temperaturen von 140 bis 230 °C, bevorzugt 180 bis 200 °C, besonders bevorzugt 185 bis 195 °C durchgeführt. Die Reaktionsdauer beträgt 0,1 bis 24 Stunden, bevorzugt 0,5 bis 6 Stunden, besonders bevorzugt 0,5 bis 2 Stunden. Somit verläuft das erfindungsgemäßer Verfahren deutlich schneller als die Verfahren des Standes der Technik (z.B. DE-A 101 04 426: Beispiel 2: 60 Stunden), wodurch das Verfahren aus ökonomischer Sicht interessant ist und einen entscheidenden Vorteil gegenüber dem Stand der Technik

bietet.

Die Menge an Lösungsmittel wird im Allgemeinen so gewählt, dass in 1 ml Lösungsmittel 0,01 bis 2,5 mmol, bevorzugt 0,2 bis 2 mmol, besonders bevorzugt 0,25 bis 0,6 mmol Iridiumhalogenid oder -pseudohalogenid vorliegen.

Der gewünschte Ir-Komplex der Formel (I) wird mit Hilfe des erfindungsgemäßen Verfahrens in einer Ausbeute von im Allgemeinen mindestens 70 %, bevorzugt mindestens 80 %, besonders bevorzugt mindestens 90 %, bezogen auf das eingesetzte Iridiumhalogenid oder -pseudohalogenid, als Rohprodukt erhalten. Unter einem Rohprodukt ist im Sinne der vorliegenden Erfindung das Produkt zu verstehen, das nach der Umsetzung ohne Reinigungsoperationen isoliert werden kann.

Das erfindungsgemäße Verfahren zeigt eine deutlich weniger stark ausgeprägte Empfindlichkeit der Reaktion gegenüber der Anwesenheit von $H_2O$ und $O_2$ als die Verfahren zur Herstellung der entsprechenden Ir-Komplexe ausgehend von $Ir(acac)_3$ gemäß dem Stand der Technik, d.h. es ist möglich, Lösungsmittel einzusetzen, die lediglich durch Einleiten von Schutzgas, bevorzugt über 1 bis 2 Stunden, oder durch kurzes Anlegen eines Vakuums von mindestens 0,1 bar mit anschließendem Einpressen von Schutzgas entgast werden, anstelle eines aufwändigen Entgasens des Lösungsmittels durch Ausfrieren.

Aufgrund des günstigen Nebenproduktspektrums werden bereits durch einfache Reinigungsschritte höchstreine Ir-Komplexe der Formel (I) in phasenreiner, bevorzugt kristalliner Form erhalten. Bevorzugt erfolgt die Aufreinigung durch Sublimation, Kristallisation, Chromatographie und/oder einfache Säulenfiltration. Die Reaktionsbedingungen und Verfahrensschritte zur Aufreinigung sind dem Fachmann bekannt. Die Säulenfiltration erfolgt im Allgemeinen über Silicagel mit einem aprotischen unpolaren Lösungsmittel. Als Lösungsmittel zur Säulenfiltration wird bevorzugt Methylenchlorid eingesetzt.

Im Anschluss an die Reinigung wird der erhaltene höchstreine Ir-Komplex der Formel (I) üblicherweise mit dem Fachmann bekannten Verfahren, z.B. bei erhöhter Temperatur, bei Raumtemperatur im Vakuum oder bei erhöhter Temperatur im Vakuum getrocknet.

Mit dem erfindungsgemäßen Verfahren wird der gewünschte höchstreine Ir-Komplex der Formel (I) nach einem einfachen Reinigungsschritt wie vorstehend angegeben in einer Reinheit von im Allgemeinen >97 %, bevorzugt > 99,5 %, bevorzugt > 99,9 % erhalten.

Der mit dem erfindungsgemäßen Verfahren hergestellte höchstreine Ir-Komplex der Formel (I) liegt bevorzugt in kristalliner Form vor.

Im Vergleich zum üblicherweise zur Herstellung von Ir-Komplexen der Formel (I) eingesetzten Herstellungsverfahren ausgehend von $Ir(acac)_3$ bietet das erfindungsgemäße Verfahren die folgenden Vorteile:

- deutlich verkürzte Reaktionszeit,
- robustere Reaktionsführung (Empfindlichkeit gegenüber $O_2/H_2O$, Entgasung der verwendeten Lösungsmittel ist weniger intensiv),
- einfache Aufreinigung durch Säulenfiltration und
- deutlich gesteigerte Produktqualität ohne organische Kontamination.

Die deutlich gesteigerte Produktqualität ohne organische Kontamination zeigt sich insbesondere bei der Verdampfung der erfindungsgemäß hergestellten Ir-Komplexe der Formel (I). Diese verdampfen völlig rückstandsfrei, während bei einer Verdampfung von entsprechenden Ir-Komplexen gemäß dem Stand der Technik ein schwarzer Rückstand aus organischem Material zurückbleibt.

Des Weiteren ist das erfindungsgemäße Verfahren auch zur Herstellung von großen Produktmengen geeignet, was für die technische Anwendung des Verfahrens wichtig ist.

Die gemäß dem erfindungsgemäßen Verfahren hergestellten Ir-Komplexe der Formel Ia entstehen im Allgemeinen vorwiegend in Form von 2 bis 10 $\mu$m langen und 1 bis 3 $\mu$m breiten Plättchen, während die entsprechenden üblicherweise hergestellten Ir-Komplexe, die Phenylpyridyl-Liganden aufweisen, (ausgehend von $Ir(acac)_3$) in Form von 1 bis 10 $\mu$m langen und ca. 0,2 $\mu$m breiten Nadeln erhalten werden (die Werte wurden durch TEM-Untersuchungen ermittelt).

Die erfindungsgemäß hergestellten Ir-Komplexe der Formel (I) sind höchstrein, bevorzugt kristallin und erhalten insbesondere keine organischen Verunreinigungen. Bei Verdampfung einer Probe des erfindungsgemäß hergestellten Ir-Komplexes der Formel (I) verbleibt daher kein Rückstand.

Mit dem erfindungsgemäßen Verfahren ist es möglich, Ir-Komplexe der Formel (Ia) in phasenreiner, bevorzugt kristalliner, Form zu erhalten. Unter phasenreiner, bevorzugt kristalliner Form ist im Sinne der vorliegenden Anmeldung das Vorliegen einer Kristallphase zu verstehen, die im Allgemeinen 0 bis 5 Gew,-%, bevorzugt 0 bis 2 Gew-%, besonders bevorzugt 0 bis 0,5 Gew,-% einer Fremdphase enthält. Ganz beonders bevorzugt liegt eine einzige Kristallphase vor, d.h. es ist keine (0 Gew.-%) Fremdphase enthalten.

Die erfindungsgemäß hergestellte Verbindung zeichnet sich gegenüber $Irppy_3$ gemäß dem Stand der Technik durch eine wesentlich verbesserte Effizienz bei der Verwendung der erfindungsgemäß hergestellten Verbindung in

OLEDs aus. Wird der erfindungsgemäß hergestellte Ir-Komplex der Formel (Ia) als Emittermolekül in OLEDs eingesetzt, so ist die Effizienz bedeutend höher als bei Einsatz einer entsprechenden gemäß dem Stand der Technik hergestellten Verbindung, wie die Beispiele und Vergleichsbeispiele der vorliegenden Anmeldung deutlich belegen. Ein objektiver Vergleich der Leuchtdichte und Effizienz der erfindungsgemäß hergestellten Verbindung mit im Stand der Technik angegebenen Daten ist schwierig, da die ermittelte Effizienz nicht monokausal von dem jeweiligen Emittern abhängt, sondern auch ganz empfindlich von der präzisen Devicearchitektur, der Messgeometrie und den Messparametern. Daher wurde in den Beispielen und Vergleichsbeispielen der vorliegenden Anmeldung eine kommerziell erhältliche Verbindung (H.W. Sands Corp., USA) mit der erfindungsgemäß hergestellten Verbindung in einem identisch aufgebauten Device (OLED) verglichen.

Bei dem im Folgenden genannten Aufbau des OLED beträgt die maximale Leuchtdichte der erfindungsgemäß hergestellten Verbindung 100.000 cd/$m^2$ bei einer Emitterschichtdicke von 50 nm. Der entsprechende Wert für das kommerziell erhältliche Material (H.W. Sands Corp., USA) liegt bei 80.000 cd/$m^2$. Somit ist die maximale Leuchtdichte wesentlich höher (um ca. 25 %) als bei den $Irppy_3$-Verbindungen des Standes der Technik.

Aufbau des verwendeten OLEDs:

ITO (Indium-Zinn-Oxid) / NPD (Schichtdicke: ca. 40 nm) / CBP-$Ir(ppy)_3$ (ca. 6 Vol.-%) (Schichtdicke: 10 bis 40 nm) / BCP (Schichtdicke: ca. 6 nm) / $Alq_3$ (Schichtdicke: ca. 20 nm) / LiF (Schichtdicke: ca. 2 nm) / Al

Die Effizienz in den OLEDs kann durch folgende Parameter definiert werden:

<u>Leuchtdichte (luminance) L (cd/$m^2$):</u>

Diese ist der Quotient aus Lichtstärke und leuchtender Fläche. Die Leuchtdichte kann direkt mit einem Leuchtdichtemeßgerät bestimmt werden.

<u>Photometrischer Wirkungsgrad (luminous efficiency) $\eta_{ph}$ (cd/A):</u>

$$\eta_{ph} = L/J$$

der photometrische Wirkungsrad ist der Quotient aus Leuchtdichte und Stromdichte

Die interne Quanteneffizienz kann weiter zerlegt werden in die Quanteneffizienzen der zugrunde liegenden physikalischen Teilprozesse. Hierbei muss unterschieden werden, ob es sich um einen Fluoreszenzemitter oder z.B. um einen phosphoreszierenden Triplettemitter in einem Host - Material handelt.

OLEDs enthaltend den erfindungsgemäß hergestellten Ir-Komplex der Formel (Ia) als Emitter zeigen im Vergleich zu OLEDs enthaltend Verbindungen des Standes der Technik (H.W. Sands Corp., USA) als Emitter weitere vorteilhafte Eigenschaften:

- Die Leuchtdichte bei einer Stromdichte von 10 mA/$cm^2$ ist bei OLEDs enthaltend die erfindungsgemäß hergestellte Verbindung größer als bei den OLEDs enthaltend Verbindungen des Standes der Technik. Bei Einsatz eines OLEDs mit dem oben genannten Aufbau beträgt die Leuchtdichte bei einer Stromdichte von 10 mA/$cm^2$ 2565 cd/$m^2$ bei einer Emitterschichtdicke von 50 nm. Der entsprechende Wert für das nach dem Stand der Technik (H.W. Sands Corp., USA) bekannte Material liegt bei 2331 cd/$m^2$.
- Der maximale photometrische Wirkungsgrad ist, bei OLEDs enthaltend die erfindungsgemäß hergestellte Verbindung größer als bei den OLEDs enthaltend Verbindungen des Standes der Technik. Bei Einsatz eines OLEDs mit dem oben genannten Aufbau beträgt der maximale photometrische Wirkungsgrad 25 - 26 cd/A bei einer Emitterschichtdicke von 50 nm. Der entsprechende Wert für das nach dem Stand der Technik (H.W. Sands Corp., USA) hergestellte Material liegt bei 23 - 24 cd/A.
- Der photometrische Wirkungsgrad bei einer Leuchtdichte von 100 cd/$m^2$ ist bei OLEDs enthaltend die erfindungsgemäß hergestellte Verbindung größer als bei den OLEDs enthaltend Verbindungen des Standes der Technik. Bei Einsatz eines OLEDs mit dem oben genannten Aufbau beträgt der photometrische Wirkungsgrad bei einer Leuchtdichte von 100 cd/$m^2$ 17,8 - 18,8 cd/A bei einer Emitterschichtdicke von 30 bzw. 40 nm. Die entsprechenden Werte für das nach dem Stand der Technik (H.W. Sands Corp., USA) bekannte Material liegen bei 16 - 15 cd/A.

Somit zeichnet sich der erfindungsgemäß hergestellte Ir-Komplex der Formel (Ia) ($Irppy_3$) durch eine höhere maximale Leuchtdichte, eine höhere Leuchtdichte bei einer Stromdichte von 10 $mA/cm^2$, einen größeren maximalen photometrischen Wirkungsgrad, einen höheren photometrischen Wirkungsgrad bei einer Leuchtdichte von 100 $cd/m^2$ und eine höhere Lichtausbeute bei einer Leuchtdichte von 100 $cd/m^2$ aus als ein entsprechender kommerziell erhältlicher Ir-Komplex ($Irppy_3$).

In Fig. 2 ist das XRD Pulverdiffraktogramm von nach dem erfindungsgemäßen Verfahren hergestellten $Irppy_3$ dargestellt. Im Vergleich dazu ist in Fig. 3 das XRD Pulverdiffraktogramm von kommerziell erhältlichem (H.W. Sands Corp., USA) $Irppy_3$ dargestellt. Wie deutlich zu erkennen ist, liegt das nach dem erfindungsgemäßen Verfahren hergestellte $Irppy_3$ in phasenreiner Form vor, während das kommerziell erhältliche $Irppy_3$ in Form mehrerer Phasen vorliegt.

Im Vergleich zu den genannten Daten der erfindungsgemäßen Verbindung weisen die Ir(III)-Komplexe gemäß Vladimir V. Grushin et al., Chem. Commun., 2001, 1494-1495, die in einem lösungsmittelfreien Verfahren hergestellt werden und aufgereinigt werden müssen, lediglich einen photometrischen Wirkungsgrad von 3,8 cd/A auf.

Ir-Komplexe der allgemeinen Formel (Ib), die Strukturdaten gemäß der vorliegenden Erfindung aufweisen, sind aus dem Stand der Technik nicht bekannt. Die erfindungsgemäß hergestellte Verbindung der Formel (Ib) zeichnet sich gegenüber entsprechenden Ir-Komplexen gemäß dem Stand der Technik durch eine wesentlich verbesserte Effizienz bei der Verwendung der erfindungsgemäß hergestellten Verbindung in OLEDs aus. Der erfindungsgemäß hergestellte Ir-Komplex der Formel (Ib) zeigt eine sehr gute Effizienz bei Einsatz als Emittermolekül in OLEDs.

Die erfindungsgemäß hergestellten Ir-Komplexe der Formel (Ia) und (Ib) sowie die weiteren gemäß dem erfindungsgemäßen Verfahren hergestellten Ir-Komplexe der Formel (I) zeichnen sich insbesondere durch eine hohe Effizienz bei Einsatz als Emittermolekül in OLED aus.

Die Ir-Komplexe gemäß Formel I hergestellt nach dem erfindungsgemäßen Verfahren können als Emittermolekül im organischen Licht-emittierenden Dioden (OLEDs) eingesetzt werden.

Organische Licht-emittierende Dioden (OLEDs) sind grundsätzlich aufgebaut, wie in Figur 1 dargestellt.

Darin bedeuten:

1 Anode
2 Löcher-transportierende Schicht
3 Licht-emittierende Schicht
4 Elektronen-transportierende Schicht und
5 Kathode

In den OLEDs wird die Licht-emittierende Schicht durch Anlegen einer Spannung aktiviert.

Die erfindungsgemäß hergestellten Ir-Komplexe der Formel (I) werden bevorzugt in der Licht-emittierenden Schicht (3) als Emittermoleküle eingesetzt. Es ist jedoch auch möglich, die erfindungsgemäß hergestellten Ir-Komplexe in der Elektronentransportschicht (4) einzusetzen.

Es ist möglich, dass neben dem erfindungsgemäß hergestellten Ir-Komplex der Formel (I) weitere Verbindungen in der Licht-emittierenden Schicht vorliegen. Beispielsweise kann ein fluoreszierender Farbstoff anwesend sein, um die Emissionsfarbe des als Emittermolekül eingesetzten Ir-Komplexes zu verändern. Des Weiteren kann ein Verdünnungsmaterial eingesetzt werden. Dieses Verdünnungsmaterial kann ein Polymer sein, zum Beispiel Poly(N-vinylcarbazol) oder Polysilan. Das Verdünnungsmaterial kann jedoch ebenfalls ein kleines Molekül sein, zum Beispiel 4,4'-N, N'-Dicarbazolbiphenyl (CBP) oder tertiäre aromatische Amine. Wenn ein Verdünnungsmaterial eingesetzt wird, beträgt der Anteil des erfindungsgemäß hergestellten Ir-Komplexes in der Licht-emittierenden Schicht im Allgemeinen weniger als 20 Gew.-%, bevorzugt 3 bis 10 Gew.%.

Um besonders effiziente OLEDs zu erhalten, sollte das HOMO (höchstes besetztes Molekülorbital) der Löcher-transportierenden Schicht (2) mit der Arbeitsfunktion der Anode angeglichen sein und das LUMO (niedrigstes unbesetztes Molekülorbital) der Elektronen-transportierenden Schicht (4) sollte mit der Arbeitsfunktion der Kathode angeglichen sein.

Die weiteren Schichten in dem OLED können aus einem beliebigen Material aufgebaut sein, das üblicherweise in solchen Schichten eingesetzt wird.

Die Anode (1) ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in

Kirk-Othmer Encyclopedia of Chemical Technologie, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl ($\alpha$-NPD), N, N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N, N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), $\alpha$-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB) und Porphyrinverbindungen wie Kupferphthalocyanine. Üblicherweise eingesetzte Löcher transportierende Polymere sind ausgewählt aus der Gruppe bestehend aus Polyvinylcarbazolen, (Phenylmethyl)polysilanen und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Geeignete Elektronen transportierende Materialien für die Schicht (4) der OLEDs umfassen mit oxinoiden Verbindungen chelatisierte Metalle wie Tris(8-hydroxychinolato)aluminium ($Alq_3$), Verbindungen auf Phenanthrolinbasis wie 2,9-Dimethyl, 4,7-diphenyl-1, 10-phenantrolin (DDPA) oder 4,7-Diphenyl-1, 10-phenantrolin (DPA) und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten des OLEDs zu vermeiden. Vorzugsweise verbessert die Schicht (4) die Beweglichkeit der Elektronen und reduziert ein Quenchen des Excitons. Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen zwischen der organischen Schicht und der Kathode aufgebracht werden, um die Betriebsspannung (Operating Voltage) zu vermindern.

Das OLED kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält das OLED zusätzlich zu den Schichten (1) bis (5) mindestens eine der im Folgenden genannten weiteren Schichten:

- eine Loch-Injektionsschicht zwischen der Anode (1) und der Löcher-transportierenden Schicht (2);
- eine Blockschicht für Elektronen zwischen der Löcher-transportierenden Schicht (2) und der Licht-emittierenden Schicht (3);
- eine Blockschicht für Löcher zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Geeignete Substanzen für die einzelnen Schichten sind dem Fachmann bekannt und z.B. in WO 00/70655 offenbart.

Des Weiteren kann jede der genannten Schichten des OLEDs aus zwei oder mehreren Schichten ausgebaut sein. Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, ein OLED mit einer hohen Effizienz zu erhalten.

Die Herstellung des OLEDs kann nach dem Fachmann bekannten Methoden erfolgen. Im Allgemeinen wird das OLED durch aufeinanderfolgende Dampfabscheidung (Vapor deposition) der einzelnen Schichten auf ein geeignetes Substrat hergestellt. Geeignete Substrate sind zum Beispiel Glas oder Polymerfilme. Zur Dampfabscheidung können übliche Techniken eingesetzt werden wie thermische Verdampfung, Chemical Vapor Deposition und andere. In einem alternativen Verfahren können die organischen Schichten aus Lösungen oder Dispersionen in geeigneten Lösungsmitteln beschichtet werden, wobei dem Fachmann bekannte Beschichtungstechniken angewendet werden.

Im Allgemeinen haben die verschiedenen Schichten folgende Dicken: Anode (2) 500 bis 5000 Å, bevorzugt

1000 bis 2000 Å; Löcher-transportierende Schicht (3) 50 bis 1000 Å, bevorzugt 200 bis 800 Å, Licht-emittierende Schicht (4) 10 bis 1000 Å, bevorzugt 100 bis 800 Å, Elektronen transportierende Schicht (5) 50 bis 1000 Å, bevorzugt 200 bis 800 Å, Kathode (6) 200 bis 10.000 Å, bevorzugt 300 bis 5000 Å. Die Lage der Rekombinationszone von Löchern und Elektronen in dem OLED und somit das Emissionsspektrum des OLED können durch die relative Dicke jeder Schicht beeinffusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in dem OLED ist von den eingesetzten Materialien abhängig. Die Schichtdicken von gegebenenfalls eingesetzten zusätzlichen Schichten sind dem Fachmann bekannt.

Durch Einsatz der erfindungsgemäß hergestellten Ir-Komplexe der Formel (I) als Emittermolekül in der Licht-emittierenden Schicht der OLEDs können OLEDs mit hoher Effizienz erhalten werden. Die Effizienz der OLEDs kann des Weiteren durch Optimierung der anderen Schichten verbessert werden. Beispielsweise können hoch effiziente Kathoden wie Ca, Ba oder LiF eingesetzt werden. Geformte Substrate und neue Löcher-transportierende Materialien, die eine Reduktion der Operationsspannung oder eine Erhöhung der Quanteneffizienz bewirken, sind ebenfalls in den OLEDs einsetzbar. Des Weiteren können zusätzliche Schichten in den OLEDs vorhanden sein, um die Energielevel der verschiedenen Schichten einzustellen und um Elektrolumineszenz zu erleichtern.

Die OLEDs können in allen Vorrichtungen eingesetzt werden, worin Elektrolumineszenz nützlich ist. Geeignete Vorrichtungen sind bevorzugt ausgewählt aus stationären und mobilen Bildschirmen. Stationäre Bildschirme sind z.B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Fahrzeugen sowie Zielanzeigen an Bussen und Bahnen.

Des Weiteren ist es denkbar, dass die erfindungsgemäß hergestellten Ir-Komplexe der Formel (I) in anderen Anwendungen als in den OLEDs eingesetzt werden können. Beispiele für solche anderen Anwendungen sind der Einsatz der erfindungsgemäß hergestellten Ir-Komplexe der Formel (I) als sauerstoffempfindliche Indikatoren, als phosphoreszierende Indikatoren in Bio-Essays und als Katalysatoren.

Weiterhin können die erfindungsgemäß hergestellten Ir-Komplexe der Formel (I) in OLEDs mit inverser Struktur eingesetzt werden. Bevorzugt werden die Ir-Komplexe der Formel (I) in diesen inversen OLEDs in der Licht-emittierenden Schicht eingesetzt. Der Aufbau von inversen OLEDs und die üblicherweise darin eingesetzten Materialien sind dem Fachmann bekannt.

Die nachfolgenden Beispiele erläutern die Erfindung zusätzlich.

**Beispiele**

*1. Darstellung von Irppy$_3$*

1.1 Darstellung von Irppy$_3$(K. Dedeian et al. Inorg. Chem. 1991, 30, 1685-1687) (Vergleichsversuch, "acac-Route")

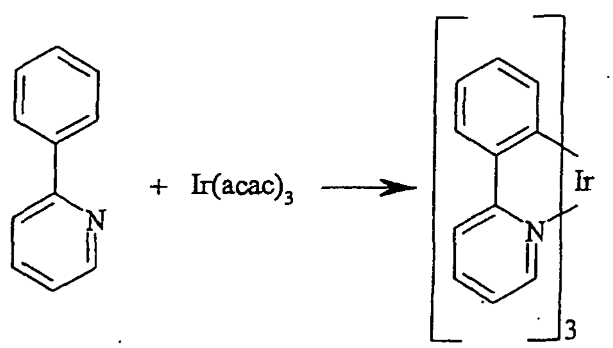


657,8 g/mol

Ansatz:

| | | |
|---|---|---|
| $Ir(acac)_3$ | 2,50 g | 5,10 mmol |
| 2-Phenylpyridin, destilliert | 3,17 g | 20,4 mmol |
| Glycerin | 100 ml | |

Durchführung:

In einem Vierhalskolben mit Rückflusskühler und Zweiwegehahn wurden in 100 ml ausgefrorenem Glycerin 3,17 g Phenylpyridin vorgelegt und eine Stunde durch Einleiten mit Argon entgast. Bei einer Temperatur von 80˚C wurde $Ir(acac)_3$ unter Gegenstrom dem Ansatz zugegeben. Die erhaltene gelbe Suspension wurde auf 200˚C aufgeheizt und 18 Stunden bei dieser Temperatur gehalten. Nach dem Abkühlen wurde die Suspension über eine 75 ml G4-Fritte gegeben. Der Reaktionskolben wurde mit Mutterlauge ausgespült. Der Rückstand wurde portionsweise mit insgesamt 200 ml VE-Wasser gewaschen. Danach wurde in kleinen Portionen mit insgesamt 45 ml Methanol gewaschen. Der trockengesaugte Rückstand wurde getrocknet.

Die erhaltenen 2,20 g Rohprodukt wurden in 130 g Dichlormethan bei Raumtemperatur 1 Stunde gerührt. Die Suspension wurde über eine 125 ml G4-Fritte gegeben. Beim Nachwaschen des Nutschkuchens löste sich dieser in Dichlormethan. Die Lösung wurde über eine 1 1 G3-Fritte, die mit ca. 670 ml Dichlormethan-feuchtem Kieselgel gefüllt war, gegeben.

Ausbeute:

Es wurden nach mehrfacher Chromatographie oder HPLC 800 mg reines $Irppy_3$ erhalten (23,8 %).

Analytik

$^1$H-NMR ($CD_2Cl_2$, 400 MHz):

$\delta$ = 6.74 (ddd, 1H, $^3J$ = 7.6 Hz, $^4J$ = 1.7 Hz, $^5J$ = 0.6 Hz, 1-H), 6.79 (td, 1H, $^3J$ = 6.8 Hz, $^4J$ = 1.4 Hz, 2-H), 6.88 (ddd, 1H, $^3J$ = 7.7 Hz, $^3J$ = 6.8 Hz, $^4J$ = 1.7 Hz, 3-H), 6.92 (ddd, 1H, $^3J$ = 7.4 Hz, $^3J$ = 5.5 Hz, $^4J$ = 1.3 Hz, 7-H), 7.57 (ddd, 1H, $^3J$ = 5.5 Hz, $^4J$ = 1.7 Hz, $^5J$ = 0.9 Hz, 8-H), 7.65 (ddd, 1H, $^3J$ = 8.2 Hz, $^3J$ = 7.3 Hz, $^4J$ = 1.6 Hz, 6-H), 7.67 (ddd, 1H, $^3J$ = 7.7 Hz, $^4J$ =1.5 Hz, $^5J$ = 0.6 Hz, 4-H), 7.92 (dt, 1H, $^3J$ = 8.3 Hz, $^4J$ = 1.0 Hz, 5-H).

*1.2 Darstellung von $Irppy_3$ über die Silbersalznaethode (erfindungsgemäß, "Ag Route")*

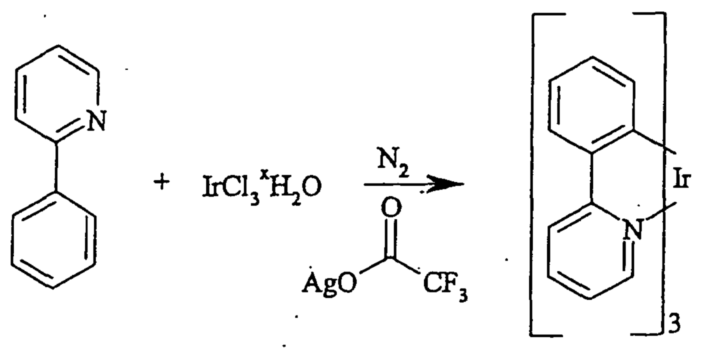


352,6 g/mol 657,8 g/mol

Ansatz:

| | | |
|---|---|---|
| $IrCl_3 . 3 H_2O$ | 2,56 g | 7,26 mmol |
| 2-Phenylpyridin, destilliert | 10,0 g | 64,5 mmol |

(fortgesetzt)

| | | |
|---|---|---|
| AgOTf | 5,05 g | 22,4 mmol |
| Glycerin (wasserfrei) | 30 ml | |

Durchführung:

Die Reaktionsapparatur, bestehend aus Vierhalskolben, Rückflusskühler, Gaseinleitungsrohr, Zweiwegehahn und Magnetrührer wurde 30 Minuten mit Stickstoff gespült. Nach Befüllten des Kolbens mit Glycerin und 2-Phenylpyridin lag eine heterogene Mischung vor, die 1 h mit Stickstoff bei 80˚C gespült wurde. Im Gegenstrom wurde Iridiumchlorid-trihydrat (dunkelgrünes Pulver) eingetragen Danach folgte die Zugabe von AgOTf.

Beim langsamen Aufheizen auf 185˚C (Solltemperatur am Regler) lag bei 100˚C eine braune Suspension vor. Nach zwei Stunden bei 185˚C wurde die Heizung abgestellt und unter Rühren unter $N_2$ abkühlen lassen.

Aufarbeitung

Man saugte den Ansatz über eine 75 ml G3-Fritte ab und wusch den Rückstand mit 200 ml Wasser und danach mit 100 ml Methanol aus. Der Rückstand wurde dann in 370 ml Methylenchlorid eine halbe Stunde bei Raumtemperatur gerührt und durch Säulenfiltration gereinigt.

Das erhaltene voluminöse hellgelbe Produkt wurde über Nacht im Vakuumtrockenschrank bei 55˚C getrocknet

Ausbeute:

Es wurden 3,50 g (73%) des gewünschten Produktes erhalten.

Analytik:

$^1$H-NMR ($CD_2Cl_2$, 400 MHz):

$\delta$ = 6.74 (ddd, 1H, $^3J$ = 7.6 Hz, $^4J$ = 1.7 Hz, $^5J$ = 0.6 $H_z$, 1-H), 6.79 (td, 1H, $^3J$ = 6.8 Hz, $^4J$ = 1.4 Hz, 2-H), 6.88 (ddd, 1H, $^3J$ = 7.7 Hz, $^3J$ = 6.8 Hz, $^4J$ =1.7 Hz, 3-H), 6.92 (ddd, 1H, $^3J$ = 7.4 Hz, $^3J$ = 5.5 Hz, $^4J$ = 1.3 Hz, 7-H), 7.57 (ddd, 1H, $^3J$ = 5.5 Hz, $^4J$ = 1.7 Hz, $^5J$ = 0.9 Hz, 8-H), 7.65 (ddd, 1H, $^3J$ = 8.2 Hz, $^3J$ = 7.3 Hz, $^4J$ = 1.6 Hz, 6-H), 7.67 (ddd, 1H, $^3j$ = 7.7 H, $^4J$ =1.5 Hz, $^5J$ = 0.6 Hz, 4-H), 7.92 (dt, 1H, $^3J$ = 8.3 Hz, $^4J$ = 1.0 Hz, 5-H).

Das erhaltene Produkt wurde mittels Röntgenpulverdiffraktometrie untersucht. Auf Basis des Pulverdiffraktogramms war es möglich, die Struktur der Verbindung zu bestimmen. $Irppy_3$ wird in phasenreiner, kristalliner Form mit folgenden mittels Pulverdiffaktometrie (XRD) ermittelten ausgewählten Bragg-Reflexen: $2\Theta$ = 10.5, 11.4, 12.9, 15.5, 16.7, 17.0, 18.2, 19.7, 21.0 und 21.5 erhalten.

In Fig. 2 ist das Röntgenpulverdiffraktogramm ($CuK_\alpha$) des erfindungsgemäßen $Irppy_3$ dargestellt. Auf der Abszisse sind die Winkel (2-Theta-Skala) und auf der Ordinate die Intensität (Lin (Counts)) angegeben.

In Fig. 3 ist das Röntgenpulverdiffraktogramm ($CuK_{\alpha}$,) von kommerziell erhältlichem $Irppy_3$ (H.W. Sands Corp., USA) dargestellt. Auf der Abszisse sind die Winkel (2-Theta- . Skala) und auf der Ordinate die Intensität (Lin (Counts)) angegeben.

Bei einem Vergleich der Röntgenpulverdiffraktogramme erkennt man, dass das erfindungsgemäße $Irppy_3$ phasenrein vorliegt, während das kommerziell erhältliche $Irppy_3$ in Form von mehreren Phasen vorliegt. Des weiteren ist an dem guten Signal-Rausch-Verhältnis in Fig. 2 gegenüber dem schlechten Signal-Rausch-Verhältnis in Fig. 3 erkennbar, dass das erfindungsgemäße $Irppy_3$ in deutlich höherer Reinheit vorliegt als das kommerziell erhältliche $Irppy_3$.

*2. Darstellung von $Ir(btp)_3$*

*2.1 Darstellung von $Ir(btp)_3$ mit Iridiumacetylacetonat (Vergleiclisversuch, "acac-Route")*

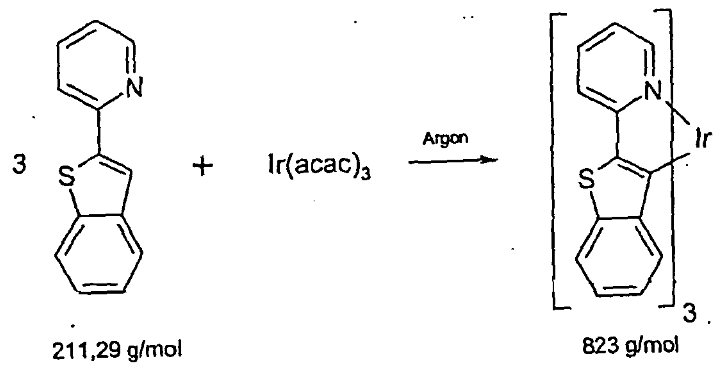


Ansatz:

| | | |
|---|---|---|
| Iridiumacetylacetonat | 0,60 g | 1,22 mmol |
| 2-Benzo[b]thiophen-2-yl-pyridin | 1,03 g | 4,87 mmol |
| Glycerin | 50 mL | |

Durchführung:

In das bei 60 °C gerührte, im Hochvakuum entgaste, Glycerin wurde eineinhalb Stunden Argon eingeleitet. Im Gegenstrom von Argon erfolgte der Eintrag. von Iridiumacetylacetonat und 2-Benzo[b]thiophen-2-yl-pyridin. Die abgedunkelte Reaktionsmischung rührte unter Argon-Atmosphäre (Gummiblase) 18 h bei Rückfluss (185 °C). Der Ansatz wurde bei 80 °C abfiltriert. Das schwarze kristalline Produkt, das sich um den Magnetfisch lagerte, schabte man zum Rückstand auf die Fritte. Der Rückstand auf der Fritte war sehr heterogen. Es waren gelbe, weiße und dunkelbraune Teilchen zu erkennen. Das Rückstandsgemisch leuchtete im UV-Licht nur sehr schwach rot. Die klare gelbe Mutterlauge leuchtete im UV-Licht nicht, sie wurde verworfen. Der Rückstand wurde mit VE-Wasser und anschließend mit Methanol gewaschen. Das gelbe Methanolfiltrat leuchtete im UV-Licht nicht, es wurde verworfen. Abschließend folgte das Waschen mit 100 mL Dichlormethan.

Der gewaschene dunkelbraune Rückstand (kein Leuchten im UV-Licht) wurde verworfen. Das Dichlormethanfiltrat leuchtete orangerot im UV-Licht, es wurde eingeengt.

Auswaage: 0,24 g/ Ausbeute: 24 % der Theorie.

DC (Dünnschichtchromatographie): Produkt ist verunreinigt ($R_f$= 0,93 auf Kieselgel, LF (Laufmittel): $CH_2Cl_2$)

*2.2 Darstellung von Ir(btp)$_3$ mit über die Silbersalzmethode (erfindungsgemäß, "Ag-Route")*

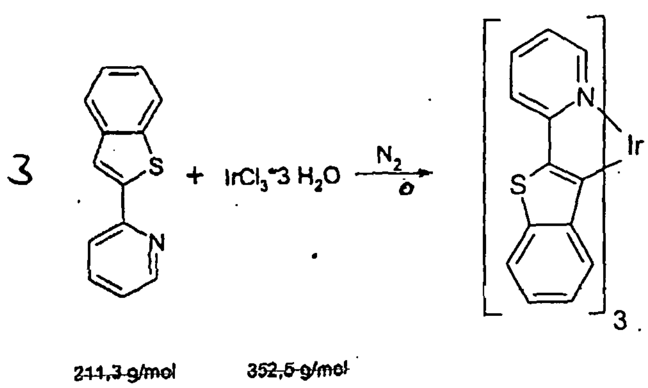

Ansatz:

| | | |
|---|---|---|
| Iridiumtrichlorid-trihydrat | 0,93 g | 2,65 mmol |
| 2-Benzo [b]thiophen-2-yl-pyridin | 5,00 g | 23,7mmol, |
| Silbertrifluoracetat | 1,85 g | 8,20mmol |
| Glycerin | 35 mL | |

Durchührung:

In das bei 100 ˚C gerührte Glycerin wurde zwei Stunden Stickstoff eingeleitet. Im Gegenstrom von Stickstoff erfolgte der Eintrag des 2-Benzo[b]thiophen-2-yl-pyridin. In die weiße Suspension trug man, ebenfalls im Stickstoffgegenstrom, das Iridiumtrichloridtrihydrat ein.

Nach drei Minuten lag eine orangene, fast vollständige Lösung vor, die nicht im UV-Licht lumineszierte. Der Eintrag des Silbersalzes ließ den Ansatz deutlich dunkler werden. Der abgedunkelte Kolben wurde bis zum Rückfluss (185 ˚C) der Reaktionsmischung aufgeheizt, Am Ende der zweibindigen Reaktionszeit lag eine rotbraune Suspension vor, die im UV-Licht nicht leuchtet. Der Ansatz kühlte unter Rühren bis 100 ˚C ab. Die gelbe Mischung, in der sich rotbrauner Feststoff am Magnetfisch anlagerte, wurde bei dieser Temperatur über eine 50 mL G4-Fritte abgetrennt. Das noch im Kolben befindliche sowie am Magnetfisch befindliche Produkt vereinigte man, zerrieb es mit einem Mörser und schlämmte es in Methanol auf. Die rotbraune Methanol-Suspension wurde über die selbe Fritte gegeben und der Rückstand mit Methanol bis zum wasserklaren Ablauf gewaschen. Der trockengesaugte rotbraune Rückstand wurde in Dichlormethan gerührt und die erhaltene Suspension über einer 50 mL G4-Fritte getrennt.

DC der roten Mutterlauge auf Kieselgelplatte im Laufmittel Dichlormethan: Produkt ($R_f$= 0,98) ist mit Ligand ($R_f$= 0,68) verunreinigt.

Die Dichlormethanlösung engte man daher auf ca. 25 mL ein und trennte die auskristallisierten roten Kristalle über eine Trichtemutsche ab. Die Kristalle wurden mit ca. 10 mL Methanol zur roten Mutterlauge gewaschen. Das Methanolfiltrat war am Ende wasserklar. Die Kristalle wurden gut trockengesaugt.

<u>Auswaage:</u> 1,67 g/ Ausbeute: 79 % der Theorie.

$R_f$= 0,93 (Kieselgel, $CH_2Cl_2$)

$^1$H-NMR ($CDCl_3$, 400 MHz):

δ = 6.58 (d, 1H, J = 8.3 Hz), 6.66 (dt, 1H, J = 7.2 Hz, J = 1.1 Hz), 6.78 (t, 1H, J = 5.5 Hz), 7.08 (t, 1H, J = 8.1 Hz), 7.37 (d, 1H, J = 5.0 Hz), 7.52-7.61 (m, 2H), 7.76 (d, 1H, J = 7.0 Hz)

*3. Darstellung von Ir(piq)$_3$*

*3.1. Darstellung von Ir(piq)$_3$ mit Iridiumacetylacetonat (Vergleichsversuch, " acac Route ")*

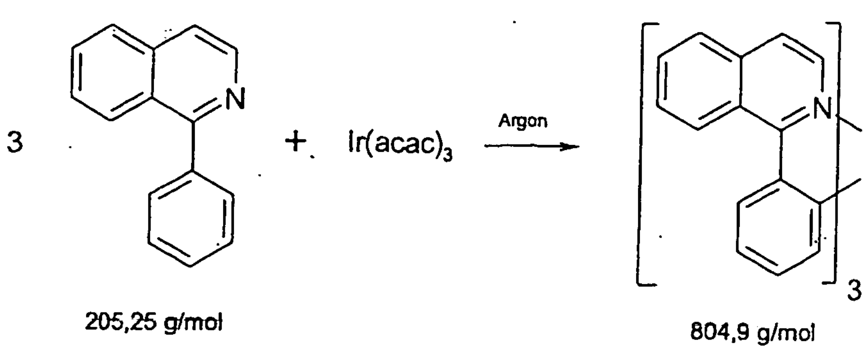

Ansatz:

| | | |
|---|---|---|
| Iridiumacetylacetonat | 0,60 g | 1,22 mmol |
| 1-Phenylisochinolin | 1,00 g | 4,87 mmol |
| Glycerin | 50mL | |

Durchführung:

In das bei 60 ˚C gerührte, im Hochvakuum entgaste, Glycerin wurde eineinhalb Stunden Argon eingeleitet. Im Gegenstrom von Argon erfolgte der Eintrag von Iridiumacetylacetonat und 1-Phenylisochinolin. Die abgedunkelte Reaktionsmischung rührte unter Argon-Atmosphäre (Gummiblase) 21 h bei Rückfluss (185 C). Die anfängliche vorliegende orangene Lösung war am Ende der Reaktionszeit eine dunkelorangene Suspension. Nach der Filtration der Suspension bei ca. 100 ˚C über eine Fritte wurde der Rückstand mit VE-Wasser gewaschen.

Auswaage: keine. Der dunkelbraune Rückstand und dessen Dichlormethanlösung sowie die mit Dichlormethan extrahierte Mutterlauge zeigte, im Vergleich zu der Synthese mit Iridiumtrichlorid-trihydrat mit Silbersalz, keine Lumineszenz! Versuch wurde nicht aufge= arbeitet.

*3.2 Herstellung von Ir(piq)$_3$ mit über die Silbersalzmethode (erfindungsgemäß, "Ag-Route")*

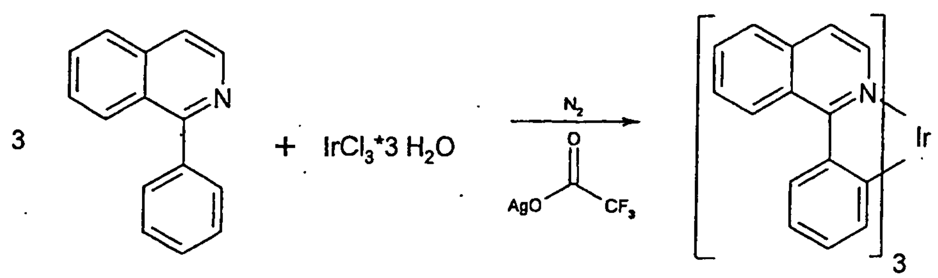


205,25 g/mol 352,6 g/mol 804,9 g/mol

Ansatz:

| | | |
|---|---|---|
| Iridiumtrichlorid-trihydrat | 0,97 g | 2,75 mmol |
| 1-Phenylisochinolin | 5,03 g | 24,5 mmol |
| Silbertrifluoracetat | 1,92 g | 8,50 mmol |
| Glycerin | 40 mL | |

Durchführung:

In das bei 100 ˚C gerührte Glycerin wurde eineinhalb Stunden Stickstoff eingeleitet. Im Gegenstrom von Stickstoff erfolgte der Eintrag des 1-Phenylisochinolin. In die wasserklare Lösung trug man, ebenfalls im Stickstoffgegenstrom, das Iridiumfirichlorid-trihydrat und das Silbertrifluoracetat ein. Die abgedunkelte Reaktionsmischung rührte unter StickstoffAtmosphäre (Gummiblase) zwei Stunden bei Rückfluss (185 ˚C). Nach der Filtration der Suspension bei ca. 100 ˚C über eine Fritte wurde der Rückstand mit 160 mL einer Mischung aus Methanol und VE-Wasser (1:1) gewaschen und anschließend in heißem Dichlormethan gerührt und über eine Fritte gegeben. Es folgte das Einengen der Dichlormethan-Mutterlauge.

Auswaage: 1,68 g/ Ausbeute: 76,4 % der Theorie.

Masse (EI): 804.0, 805.0, 806.0 ($M^+$)

*4. Zusammenfassung der Ergebnisse aus den Metallisierungsbeispielen 1 bis* 3

Tabelle 1:

| Ligand | Phenylpyridin | | 2-Benzo[b]-thiophen-2-yl-pyridin | | Phenylisochinolin | |
|---|---|---|---|---|---|---|
| Einsatzstoffe | $Ir(acac)_3$ | $IrCl_3$ $H_2O$ Ag(OTf) | $Ir(acac)_3$ | $IrCl_3$ $H_2O$ Ag(OTf) | $Ir(acac)_3$ | $IrCl_3$ $H_2O$ AgOTf |
| Reaktionstemperatur | 200 ˚C | 185 ˚C | 185 ˚C | 185 ˚C | 185˚C | 185 ˚C |
| Reaktionszeit | 18 h | 2h | 18h | 2h | 21 h | 2h |
| Ansatzgröße | 5,10 mmol | 7,26 mmol | 4,87 mmol | 23,7 mmol | 4,87 mmol | 24,5 mmol |
| Ausbeute | 23,8 % | 73% | 24 % | 79 % | n. d. | 76,4 % |

Die Ergebnisse in der oben stehenden Tabelle 1 zeigen, dass das erfindungsgemäße Verfahren ("Ag-Route'') dem Verfahren gemäß dem Stand der Technik ("acac-Route'') in den folgenden Punkten deutlich überlegen ist:

- Reaktionsdauer
- Einfachheit der Aufreinigung
- Ausbeute.

*5. Physikalisch Ergebnisse bezüglich der Ir-Komplexe $Ir(btp)_3$ und $In(biq)_3$ gemäß den Beispielen 2.2 und 3.2*

Die Absorptions- und Emissionspektren der Ir-Komplexe $Ir(btp)_3$ und $Ir(biq)_3$ wurden bei einer Konzentration von 2 mg/L in Toluol gemessen. Die Lumineszenzquantenausbeuten wurden bei einer konzentration von etwa 2 mg/L in luftgestättigten Toluollösungen ermittelt. Die Ergebnisse sind in der folgenden Tabelle 2 zusammengefasst.

Tabelle 2: Übersicht über die spektroskopischen Daten der erhaltenen zyklometallierten Verbindungen

| Ir-Komplex | LM | $\lambda_{abs}$ max nm | $\lambda_{em}$ max nm | QY % | CIE 1931 x | CIE 1931 Y | | $\lambda_{em}$ Pulver nm | $\lambda_{max}$ | CIE 1931 x | CIE 1931 Y |
|---|---|---|---|---|---|---|---|---|---|---|---|
| $Ir(biq)_3$ | Toluol | 431 | 618 | 1,3 | 0,53 | 0,26 | Pulver | 667 | | 0,65 | 0,33 |
| $Ir(btp)_3$ | Toluol | 408 | 597 | 0,2 | 0,55 | 0,36 | Pulver | 614/645 | | 0,63 | 0,33 |

In Tabelle 2 bedeuten:

| | |
|---|---|
| LM | Lösungsmittel |
| $\lambda_{abs\ max}$ | maximale Absorptionswellenlänge |
| $\lambda_{em\ max}$ | maximale Emissionswellenlänge |
| QY | Quantenausbeute (die Quantenausbeute wurde in Anlehnung an die in J.W. Eastman, J. Photochem. Photobiol., 6, 55-72, 1967; J.N. Demas, G.A. Crossby, J. Phys. Chem. 75, 991-1025, 1971 (Review) und D.F. Eaton, J. Photochem. Photobiol., 2, 523-531, 1988 offenbarten Methoden ermittelt) |
| CIE 1931 | Commission Internationale de L'Eclairage, Chromatizitäts-Koordinaten |

Die Quantenausbeute QY ist die interne Quantenausbeute und gibt das Verhältnis der Anzahl von emittierten Photonen zur Gesamtzahl an absorbierten Photonen an.

In Tabelle 2 wurden zum einem Angaben zu den oben genannten physikalischen Eigenschaften in Toluol (d. h. in Lösung) und zum anderen Angaben zu den oben genannten Eigenschaften in Substanz (d. h. in Pulverform) gemacht.

In Figur 4 ist das Röntgenpulverdiffaktogramm ($CuK_\alpha$) des erfindungsgemäß hergestellten $Ir(btp)_3$ dargestellt. Auf der Abszisse sind die Winkel (2-Theta-Skala) und auf der Ordinate die Intensität (Lin(Counts)) angegeben.

*6. Anwendung von $Irppy_3$ in OLEDs*

Kommerziell erhältliches $Irppy_3$ (H.W. Sands Corp., USA) und das erfindungsgemäß (Beispiel 1.2; "Ag-Route") hergestellte $Irppy_3$ wurden in jeweils einem OLED mit dem folgenden Aufbau gestestet:

| | |
|---|---|
| Anode: | ITO (Indium-Zinn-Oxid) |
| Löcher-transportierende Schicht: | α-NPD (4,4'-Bis[N-(1-naphthyl)-N-phenyl-amino]- biphenyl) (Dicke: ca. 40 nm) |
| Licht-emittierende Schicht: | CBP (4,4'-N,N'-Dicarbazolbiphenyl) mit 6 Vol.-% $Irppy_3$ (Dicke: ca. 20 bis 50 nm) |
| Blockschicht für Löcher: | BCP (2,9-Dimethyl-4,7-diphenyl-1,10-phenanthrolin) (Dicke: ca. 6 mn) |
| Elektronen-transportierende Schicht:$Alq_3$ | (Tris(8-hydroxychinolato)aluminium) (Dicke: ca. 20 nm) |
| Elektronen-Injektionsschicht: | LiF (Dicke: ca. 2 nm) |
| Kathode: | Al |

In der folgenden Tabelle 3 sind die Performances von OLEDS bei Einsatz von $Irppy_3$ gemäß der vorliegenden Erfindung ("Ag-Route") und bei Einsatz von kommerziell erhältlichem $Irppy_3$ von H.W. Sands Corp., USA ("Sands") einander gegenübergestellt.

Tabelle 3: Performances von OLEDs bei Einsatz von $Irppy_3$

| Verbindung | Dicke [nm] | max. Leuchtdichte [$cd/m^2$] | Photom Wirkungsgrad bei 100cd/m2 [cd/A] | Leuchtdichte Bei 10 $mA/cm^2$ | Max. Photom. Wirkungsgrad [cd/A] |
|---|---|---|---|---|---|
| "Ag-Ronte" (Bsp. 1.2) | 30 | 67350 | 17.8 | 1956 | 20.1 |
| | 40 | 88370 | 18.8 | 2330 | 23.3 |
| | 50 | 102100 | 18.0 | 2565 | |
| "Sands" | 30 | 52580 | 16.0 | 1762 | 18.1 |
| | 40 | 67680 | 15.1 | 2237 | 22.4 |
| | 50 | 79340 | 18.5 | 2331 | 23.7 |

In der Tabelle bedeuten die in den Spalten genannten Begriffe:

| | |
|---|---|
| Verbindung: | eingesetztes $Irppy_3$, bzw. Verfahren, nach dem das eingesetzte $Irppy_3$ hergestellt wurde ("Sands": Vergleichsversuch, Bsp. 1.2: erfindungsgemäßes Beispiel 1.2) |
| Dicke: | Dicke der Emitterschicht in nm |
| Max. Leuchtdichte: | maximale. Leuchtdichte in $cd/m^2$ bei der in der rechts benachbarten Spalte angegebenen Spannung |
| Photom. Wirkungsgrad bei | Photometrischer Wirkungsgrad in cd/A bei einer |
| 100 cd/m2 | Leuchtdichte von 100 $cd/m^2$ und bei der in der rechts benachbarten Spalte angegebenen Spannung |
| Max. Photom. | Maximaler photometrischer Wirkungsgrad in cd/A bei der in |
| Wirkungsgrad | der rechts benachbarten Spalte angegebenen Spannung |

Aus der Tabelle ergibt sich, dass

- bei 30, 40 und 50 nm dicken Emitterschichten bei Einsatz des erfindungsgemäß hergestellten $Irppy_3$ (Beispiel 1.2) höhere maximale Leuchtdichten erreicht werden
- bei 30 und 40 nm dicken Emitterschichten bei Einsatz des erfindungsgemäß hergestellten $Irppy_3$ (Beispiel 1.2)

höhere photometrische Wirkungsgrade bei einer Leuchtdichte von 100 cd/m2 erreicht werden

- bei 30, 40 und 50 nm dicken Emitterschichten bei Einsatz des erfindungsgemäß hergestellten $Irppy_3$ (Beispiel 1.2) höhere Leuchtdichten bei einer Stromdichte von 10 $mA/cm^2$ erreicht werden
- bei 30, 40 und 50 nm dicken Emitterschichten bei Einsatz des erfindungsgemäß hergestellten $Irppy_3$ (Beispiel 1.2) höhere maximale photometrische Wirkungsgrade erreicht werden.

**Patentansprüche**

**1.** Verfahren zur Herstellung von Verbindungen der Formel (I)

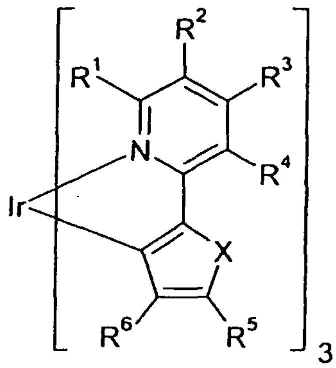

(I)

worin bedeuten

X $-CR^7=CR^8-$, -S-, $-NR^9-$, -O-, -Se-,
$R^1$, $R^2$, $R^3$, $R^4$, $R^5$, $R^6$, $R^7$ und $R^8$ unabhängig voneinander H, geradkettiges oder verzweigtes $C_{1-20}$-Alkyl, cyclisches $C_{3-20}$-Alkyl, wobei eine oder mehrere nicht benachbarte $CH_2$-Gruppen der Alkylgruppen durch -O-, -S-, $-NR^{10}-$, oder $-CON-R^{11}-$ ersetzt sein können, und ein oder mehrere H-Atome der Alkylgruppen durch F, Cl, Br oder CN ersetzt sein können; Aryl oder Heteroaryl mit einem Grundgerüst mit 4 bis 14 C-Atomen, wobei ein oder mehrere C-Atome durch Heteroatome ausgewählt aus -O-, -S-, -N- und -P- ersetzt sein können, und die C-Atome und gegebenenfalls die Heteroatome mit nicht aromatischen Substituenten, wie für $R^1$ bis $R^8$ definiert, substituiert sein können; F, Cl, Br oder CN;
oder
zwei benachbarte Reste $R^1$, $R^2$, $R^3$, $R^4$, $R^5$, $R^6$, $R^7$ und $R^8$ bilden gemeinsam einen cyclischen Rest, der wiederum mit den bezüglich $R^1$, $R^2$, $R^3$, $R^4$, $R^5$, $R^6$, $R^7$ und $R^8$ genannten Gruppen substituiert sein kann, wobei zwei benachbarte Substituenten des cyclischen Rests wiederum einen cyclischen Rest bilden können;
$R^9$, $R^{10}$, $R^{11}$ unabhängig voneinander H, geradkettiges oder verzweigtes $C_{1-20}$-Alkyl, cyclisches $C_{3-20}$-Alkyl, das wie bezüglich der Reste $R^1$ bis $R^8$ definiert substituiert sein kann oder Aryl oder Heteroaryl wie bezüglich $R^1$ bis $R^8$ definiert;

durch Umsetzung eines Liganden der Formel (II)

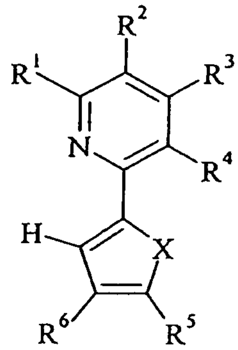

(II)

worin die Symbole $R^1$, $R^2$, $R^3$, $R^4$, $R^5$, $R^6$ und X die vorstehend genannten Bedeutungen aufweisen, mit einem Iridiumhalogenid oder -pseudohalogenid der Formel $IrZ_3$ oder $IrZ_3 \cdot L_x$, worin Z ein Halogenid oder Pseudohalgenid bedeutet und L ein organisches oder anorganisches Molekül ist, und x die Anzahl von L ist und 1 bis 3 ist; in Anwesenheit eines Halogenid-Fängers ausgewählt aus der Gruppe bestehend aus Ag-, Hg-, Sb- und Al-Salzen,
in einem Lösungsmittel ausgewählt aus der Gruppe bestehend aus Monoaryloxyethanol, Monoalkyloxyethanol, Decalin, Glycerin und Gemischen der vorstehend genannten Lösungsmittel,
wobei die Reaktionsdauer 0,1 bis 24 Stunden beträgt, und
das Verhältnis von Iridiumhalogenid oder -pseudohalogenid, Ligand der Formel II und Halogenidfänger 1:6 bis 10:3,1 bis 3,5 beträgt.

**2.** Verfahren nach Anspruch 1, **dadurch gekennzeichnet, dass**

X -CH=CH- oder -S- bedeutet.

**3.** Verfahren nach Anspruch 2, **dadurch gekennzeichnet, dass**

X -CH=CH-

und

$R^1$, $R^2$, $R^3$, $R^4$, $R^5$, $R^6$ jeweils H bedeuten,

oder

X CH=CH-

und

$R^1$, $R^2$, $R^5$, und $R^6$ jeweils H bedeuten

und

$R^3$ und $R^4$ gemeinsam einen 6-gliedrigen aromatischen Rest, der unsubstituiert ist, bilden

oder

X -S-

und

$R^1$, $R^2$, $R^3$, $R^4$ jeweils H bedeuten

und

$R^5$, $R^6$ gemeinsam einen 6-gliedrigen aromatischen Rest, der unsubstituiert ist, bilden.

4. Verfahren nach einem der Ansprüche 1 bis 3, **dadurch gekennzeichnet, dass** das Verfahren bei einer Temperatur von 140 bis 230 ˚C, bevorzugt 180 bis 200 ˚C, besonders bevorzugt 185 bis 195 ˚C durchgeführt wird.

5. Verfahren nach einem der Ansprüche 1 bis 4, **dadurch gekennzeichnet, dass** und die Menge an Lösungsmittel bevorzugt so gewählt wird, dass in 1 ml Lösungsmittel 0,01 bis 2,5 mmol, bevorzugt 0,2 bis 2 mmol, besonderes bevorzugt 0,25 bis 0,6 mmol Iridiumhalogenid oder -pseudohalogenid vorliegen.

6. Verfahren nach einem der Ansprüche 1 bis 5, **dadurch gekennzeichnet, dass** die erhaltene Verbindung der Formel (I) durch Sublimation, Kristallisation, Chromatographie oder einfache Säulenfiltration gereinigt wird.

**Claims**

1. A process for preparing compounds of the formula (I)

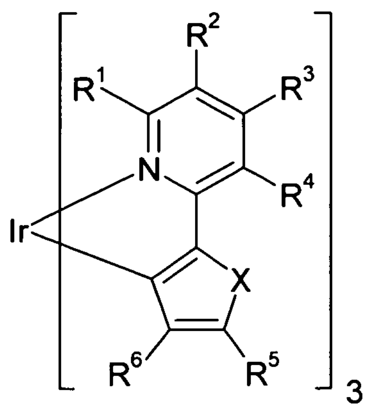

(I)

where

X is $-CR^7=CR^8-$ -S-, $-NR^9-$, -O-, -Se-,
$R^1$, $R^2$, $R^3$, $R^4$, $R^5$, $R^6$ $R^7$ and $R^8$ are each, independently of one another, H, straight-chain or branched $C_{1-20}$-alkyl, cyclic $C_{3-20}$-alkyl, where one or more nonadjacent $CH_2$ groups of the alkyl groups may be replaced by -O-, -S-, $-NR^{10}-$, or $-CONR^{11}-$ and one or more H atoms of the alkyl groups may be replaced by F, Cl, Br or CN; aryl or heteroaryl having a skeleton having from 4 to 14 carbon at- oms, where one or more carbon atoms may be replaced by heteroatoms selected from among -O-, -S-, -N- and -P- and the carbon atoms and any heteroatoms may be substituted by nonaromatic substituents as defined for $R^1$ to $R^8$; F, Cl, Br or CN;
or
two adjacent radicals $R^1$, $R^2$, $R^3$, $R^4$, $R^5$, $R^6$, $R^7$ and $R^8$ together form a cyclic radical which may in turn be substituted by the groups mentioned for $R^1$, $R^2$, $R^3$, $R^4$, $R^5$, $R^6$, $R^7$ and $R^8$, where two adjacent substituents of the cyclic radical may in turn form a cyclic radical;
$R^9$, $R^{10}$, $R^{11}$ are each, independently of one another, H, straight-chain or branched $C_{1-20}$-alkyl, cyclic $C_{3-20}$-alkyl which may be substituted as defined for the radicals $R^1$ to $R^8$, or aryl or heteroaryl is defined as for $R^1$ to $R^8$;

by reacting a ligand of the formula (II)

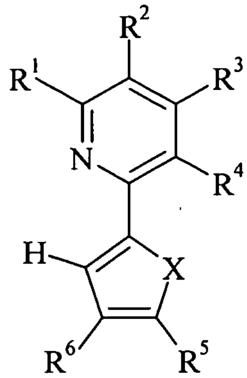

(II)

where the symbols $R^1$, $R^2$, $R^3$, $R^4$, $R^5$, $R^6$ and X are as defined above, with an iridium halide or pseudohalide of the formula $IrZ_3$ or $IrZ_3 \cdot L_x$, where Z is a halide or pseudohalide and L is an organic or inorganic molecule and x is the number of molecules L and is from 1 to 3; in the presence of a halide scavenger selected from the group consisting of Ag, Hg, Sb and A1 salts; in a solvent selected from the group consisting of monoaryloxyethanol, monoalkyloxyethanol, decalin, glycerin, and mixtures of the above-mentioned solvents; wherein the reaction time is from 0.1 to 24 hours; and wherein the ratio of iridium halide or pseudohalide, ligand of the formula II and halide scavenger is 1 : 6 - 10 : 3.1 - 3.5.

**2.** The process according to claim 1, wherein

X is -CH=CH- or -S-.

**3.** The process according to claim 2, wherein

X is -CH=CH-

and

$R^1$, $R^2$, $R^3$, $R^4$, $R^5$, $R^6$ are each H,

or

X is CH=CH-

and

$R^1$, $R^2$, $R^5$ and $R^6$ are each H,

and

$R^3$ and $R^a$ together form a 6-membered aromatic radical which is unsubstituted

or

X is -S-

and

$R^1$, $R^2$, $R^3$, $R^4$ are each H

and

$R^5$, $R^6$ together form a 6-membered aromatic radical which is unsubstituted.

**4.** The process according to any of claims 1 to 3 which is carried out at from 140 to 230°C, preferably from 180 to 200°C, particularly preferably from 185 to 195°C.

**5.** The process according to any of claims 1 to 4, wherein the amount of solvent is preferably chosen so that from 0.01 to 2.5 mmol, preferably from 0.2 to 2 mmol, particularly preferably from 0.25 to 0.6 mmol, of iridium halide or pseudohalide is present in 1 ml of solvent.

**6.** The process according to any of claims 1 to 5, wherein the compound of the formula (I) obtained is purified by sublimation, crystallization, chromatography or simple column filtration.

**Revendications**

**1.** Procédé de fabrication de composés de formule (I)

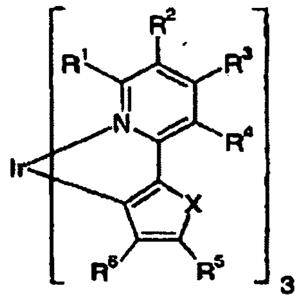

(I)

dans laquelle

X signifie $-CR^7=CR^8-$, -S-, $-NR^9-$, -O-, -Se-,
$R^1$, $R^2$, $R^3$, $R^4$, $R^5$, $R^6$, $R^7$ et $R^8$ signifient indépendamment les uns des autres H, alkyle en $C_{1-20}$ linéaire ou ramifié, alkyle en $C_{3-20}$ cyclique, un ou plusieurs groupes $CH_2$ non voisins des groupes alkyles pouvant être remplacés par -O-, -S-, $-NR^{10}-$ ou $-CONR^{11}-$, et un ou plusieurs atomes H des groupes alkyles pouvant être remplacés par F, Cl, Br ou CN ; aryle ou hétéroaryle ayant un squelette de base comportant 4 à 14 atomes C, un ou plusieurs atomes C pouvant être remplacés par des hétéroatomes choisis parmi -O-, -S-, -N- et -P-, et les atomes C et éventuellement les hétéroatomes pouvant être substitués avec des substituants non aromatiques, tels que définis pour $R^1$ à $R^8$ ; F, Cl, Br ou CN ;
ou
deux radicaux $R^1$, $R^2$, $R^3$ $R^4$, $R^5$, $R^6$, $R^7$ et $R^8$ voisins forment ensemble un radical cyclique, qui peut à nouveau être substitué avec les groupes mentionnés au regard de $R^1$, $R^2$, $R^3$, $R^4$, $R^5$, $R^6$, $R^7$ et $R^8$, deux substituants voisins du radical cyclique pouvant à nouveau former un radical cyclique ;
$R^9$, $R^{10}$, $R^{11}$ signifient indépendamment les uns des autres H, alkyle en $C_{1-20}$ linéaire ou ramifié, alkyle en $C_{3-20}$ cyclique, qui peut être substitué tel que défini au regard des radicaux $R^1$ à $R^8$, ou aryle ou hétéroaryle tel que défini au regard de $R^1$ à $R^8$ ;

par réaction d'un ligand de formule (II)

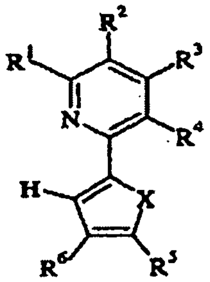

(II)

dans laquelle les symboles $R^1$, $R^2$, $R^3$, $R^4$, $R^5$, $R^6$ et X ont les significations données précédemment,
avec un halogénure ou un pseudohalogénure d'iridium de formule $IrZ_3$ ou $IrZ_3 \cdot L_x$, Z signifiant un halogénure ou un pseudohalogénure, L étant une molécule organique ou inorganique et x étant le nombre de L et allant de 1 à 3 ;
en présence d'un capteur d'halogénures choisi dans le groupe constitué des sels d'Ag, d'Hg, de Sb et d'Al, dans un solvant choisi dans le groupe constitué du monoaryloxyéthanol, du monoalkyloxyéthanol, de la décaline, de la glycérine, et de mélanges des solvants mentionnés ci-dessus,
la durée de réaction étant de 0, 1 à 24 heures, et
le rapport entre l'halogénure ou pseudohalogénure d'iridium, le ligand de formule II et le capteur d'halogénures est de 1 : 6 à 10 : 3,1 à 3,5.

2. Procédé selon la revendication 1, **caractérisé en ce que**
X signifie -CH=CH- ou -S-.

3. Procédé selon la revendication 2, **caractérisé en ce que**
X signifie -CH=CH-
et
$R^1$, $R^2$, $R^3$, $R^9$, $R^5$, $R^6$ signifient chacun H,
ou
X signifie -CH=CH-
et
$R^1$, $R^2$, $R^5$ et $R^6$ signifient chacun H
et
$R^3$ et $R^4$ forment ensemble un radical aromatique à 6 éléments, qui n'est pas substitué,
ou
X signifie -S-
et
$R^1$, $R^2$, $R^3$, $R^4$ signifient chacun H
et
$R^5$, $R^6$ forment ensemble un radical aromatique à 6 éléments, qui n'est pas substitué.

4. Procédé selon l'une quelconque des revendications 1 à 3, **caractérisé en ce que** le procédé est réalisé à une température de 140 à 230 °C, de préférence de 180 à 200 °C, de manière particulièrement préférée de 185 à 195 °C.

5. Procédé selon l'une quelconque des revendications 1 à 4, **caractérisé en ce que** la quantité de solvant est de préférence choisie de manière à ce que 0,01 à 2,5 mmoles, de préférence 0,2 à 2 mmoles, de manière particulièrement préférée 0,25 à 0,6 mmoles d'halogénure ou pseudohalogénure d'iridium soient présentes dans 1 ml de solvant.

6. Procédé selon l'une quelconque des revendications 1 à 5, **caractérisé en ce que** le composé de formule (I) obtenu est purifié par sublimation, cristallisation, chromatographie ou simple filtration sur colonne.

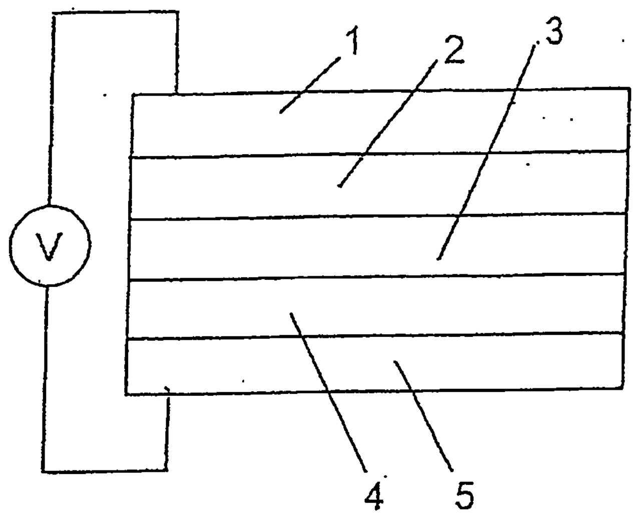


Fig. 1

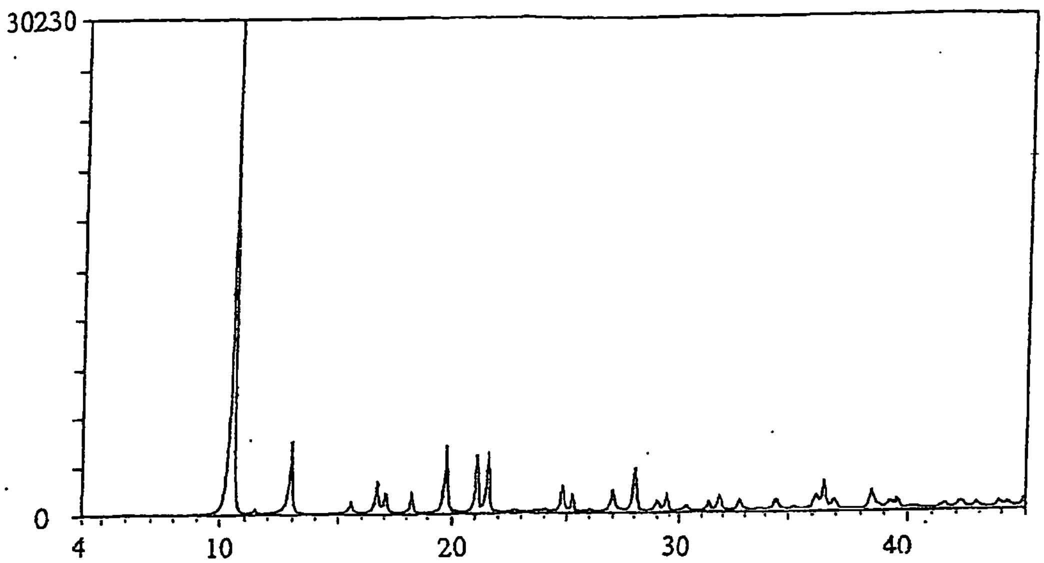


Fig. 2

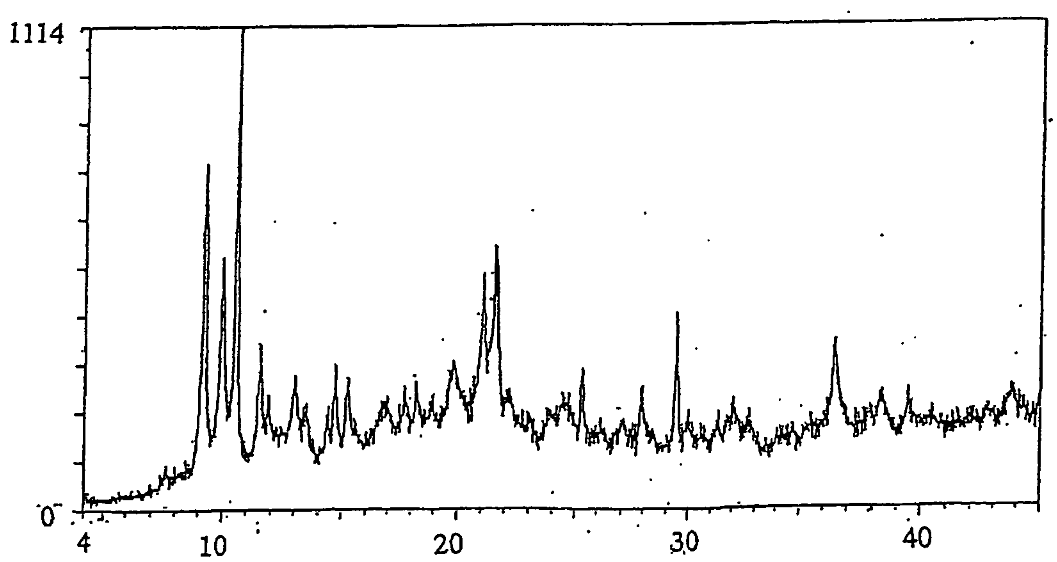


Fig. 3

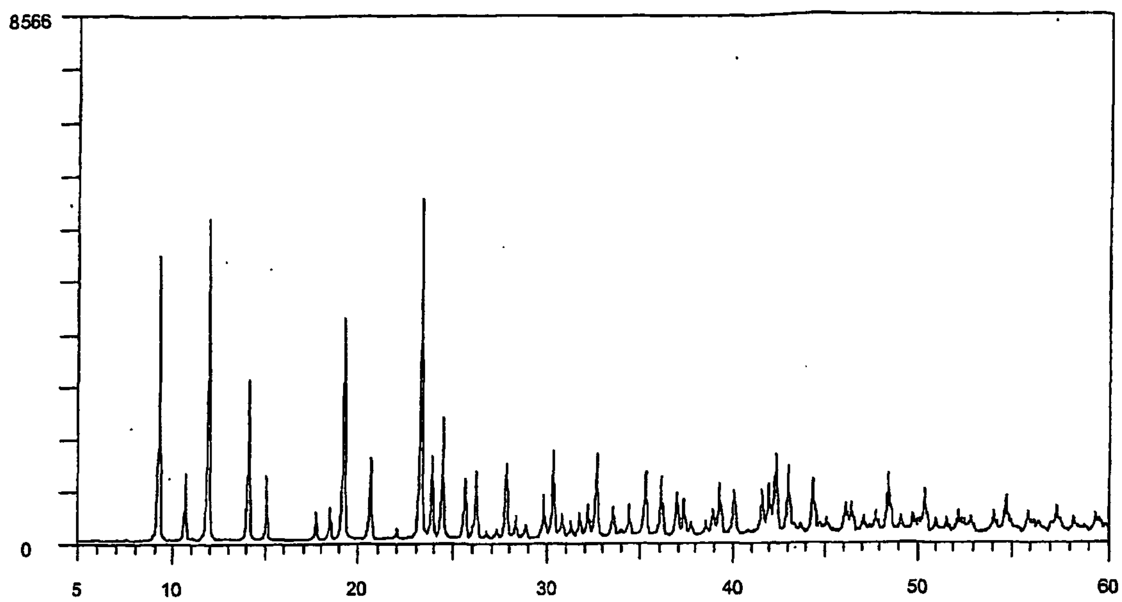


Fig. 4

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 1191612 A
- WO 03103341 A
- WO 03040256 A
- EP 1239526 A
- WO 0202714 A
- DE 10104426 A
- WO 0070655 A


### In der Beschreibung aufgeführte Nicht-Patentliteratur


- **R.J. Watts et al.** *J. Am. Chem. Soc.,* 1984, vol. 106, 6647-6653
- **R.J. Watts et al.** *Inorg. Chem.,* 1991, vol. 30, 1685-1687
- **Bürgi et al.** *Inorg. Chem.,* 1994, vol. 33, 545-550
- **Tsuboyama et al.** *J. Am. Chem. Soc.,* 2003, vol. 125, 12971-12979
- **Su et al.** *Adv. Mater.,* 2003, vol. 15, 884-888
- Encyclopedia of Chemical Technologie. 1996, vol. 18, 837-860
- **J.W. Eastman.** *J. Photochem. Photobiol.,* 1967, vol. 6, 55-72
- **J.N. Demas ; G.A. Crossby.** *J. Phys. Chem.,* 1971, vol. 75, 991-1025
- **D.F. Eaton.** *J. Photochem. Photobiol.,* 1988, vol. 2, 523-531